# FASCICULE DE BREVET EUROPEEN

(11) **EP 3 559 981 B1**
(45) Date de publication et mention de la délivrance du brevet: **14.02.2024**
(21) Numéro de dépôt: 17822326.9
(22) Date de dépôt: 22.12.2017
(51) Int. Cl.: H01L 21/285, H01L 27/144, H01L 21/768, H01L 23/485, H01L 29/45

(54) **PROCEDE DE REALISATION DE COMPOSANT COMPRENANT DES MATERIAUX III-V ET DES CONTACTS COMPATIBLES DE FILIERE SILICIUM**
VERFAHREN ZUR HERSTELLUNG EINER KOMPONENTE MIT III-V-MATERIALIEN UND KONTAKTEN, DIE MIT SILICIUMPROZESSABLÄUFEN KOMPATIBEL SIND
PROCESS FOR PRODUCING A COMPONENT COMPRISING III-V MATERIALS AND CONTACTS COMPATIBLE WITH SILICON PROCESS FLOWS

(30) Priorité: 22.12.2016 FR 1663133
(43) Date de publication de la demande: 30.10.2019
(73) Titulaire: Commissariat à l'Énergie Atomique et aux Énergies Alternatives, 75015 Paris (FR)
(72) Inventeur: GHEGIN, Elodie, 38170 Seyssinet-Pariset (FR); JANY, Christophe, 73000 Chambery (FR); NEMOUCHI, Fabrice, 38430 Moirans (FR); RODRIGUEZ, Philippe, 38140 Rives (FR); SZELAG, Bertrand, 38320 Herbeys (FR)
(74) Mandataire: Atout PI Laplace
(86) Numéro de dépôt international: PCT/EP2017/084529
(87) Numéro de publication internationale: WO 2018/115510

(56) Documents cités:
- US-A1- 2016 148 959
- US-B1- 6 596 616
- SHIGERU KURODA ET AL: "A NEW FABRICATION TECHNOLOGY FOR ALGAAS/GAAS HEMT LSI'S USING INGAAS NONALLOYED OHMIC CONTACTS", IEEE TRANSACTIONS ON ELECTRON DEVICES, IEEE SERVICE CENTER, PISACATAWAY, NJ, US, vol. 36, no. 10, 1 octobre 1989 (1989-10-01), pages 2196-2203, XP000095533, ISSN: 0018-9383, DOI: 10.1109/16.40900
- BACA A G ET AL: "A survey of ohmic contacts to III-V compound semiconductors", THIN SOLID F, ELSEVIER, AMSTERDAM, NL, vol. 308-309, 31 octobre 1997 (1997-10-31) , pages 599-606, XP004524436, ISSN: 0040-6090, DOI: 10.1016/S0040-6090(97)00439-2

## Description

Le domaine de l'invention est celui de la co-intégration de matériaux III-V sur substrat standard tel que le silicium et pouvant être réalisée sur une plateforme silicium pouvant accueillir des plaques de 100 mm de diamètre minimum. La co-intégration visée s'inscrit dans le cadre d'une intégration présentant un « back-end » planarisé compatible avec la filière Silicium 100 mm ou plus.

Les contacts actuellement intégrés sur matériaux III-V font appel à des procédés tel que le « lift-off » (le métal est déposé sur la résine et les zones d'intérêts puis la résine est dissoute ce qui retire le métal présent au dessus de la résine en laissant le métal sur les zones d'intérêts) ainsi qu'à une multitude de métaux très coûteux ou prohibés des salles blanches Silicium comme décrit dans l'article : A. Baca, F. Ren, J. Zolper, R. Briggs, and S. Pearton, "A survey of ohmic contacts to III-V compound semiconductors, " Thin Solid Films, vol. 308-309, pp. 599-606, 1997, ou dans l'article de G. Stareev, H. Kunzel, and G. Dortmann, "A controllable mechanism of forming extremely low-resistance nonalloyed ohmic contacts to group III-V compound semiconductors," Journal of Applied Physics, vol. 74, no. 12, p. 7344, 1993.

Une telle intégration, non planaire, n'ouvre pas la voie à la réalisation de plusieurs niveaux supérieurs ou à la co-intégration d'autres objets. La miniaturisation et la densification des composants sont ainsi limitées.

Finalement, la multiplication du nombre de couches présentes dans les contacts actuels (entre 3 et 5), rend l'intégration complexe et non optimale. Un exemple typique d'intégration non planaire de contacts est fourni dans les références : B. Ben Bakir, C. Sciancalepore, A. Descos, H. Duprez, D. Bordel, L. Sanchez, C. Jany, K. Hassan, P. Brianceau, V. Carron, and S. Menezo, "Heterogeneously integrated III-V on silicon lasers," Meeting Abstracts, vol. MA2014-02, no. 34, p. 1724, 2014 et H. Duprez, A. Descos, T. Ferrotti, J. Harduin, C. Jany, T. Card, A. Myko, L. Sanchez, C. Sciancalepore, S. Menezo, and B. Ben Bakir, "Heterogeneously integrated III-V on silicon distributed feedback lasers at 1310 nm," in Optical Fiber Communications Conférence and Exhibition (OFC), 2015, pp. 1-3, March 2015.

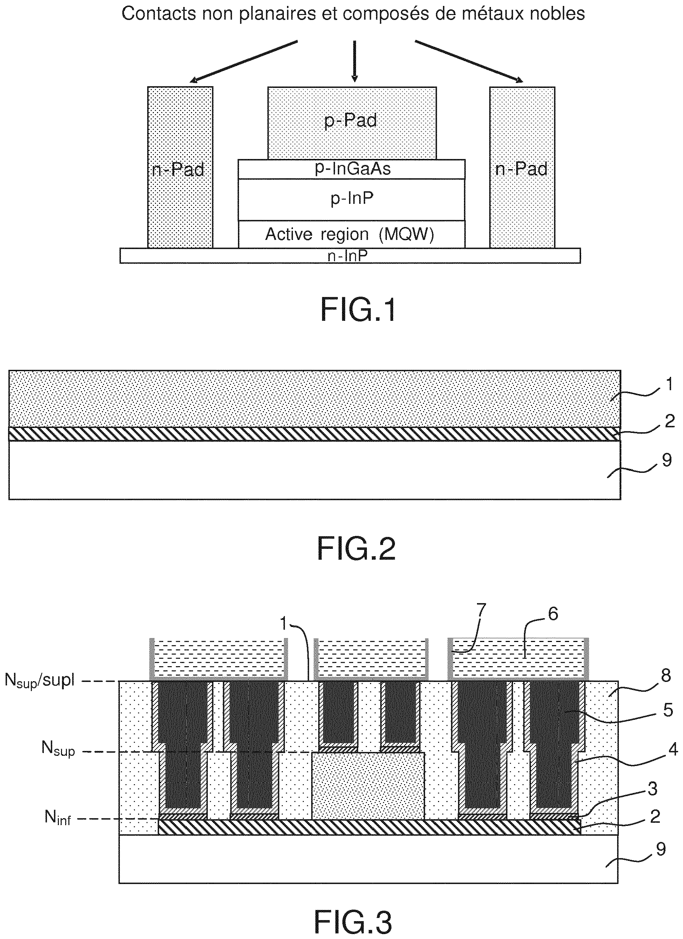

La figure 1 reprend ce type de configuration pour application laser avec des reprises de contacts non planaires et composés de métaux nobles pour reprise direct sur les matériaux III-V. Sur un substrat InP dopé n, on réalise une structure de région active à base de multi-puits quantiques MQW, sur laquelle on vient réaliser l'empilement d'une couche InP dopée p et d'une couche InGaAs dopée p. On réalise des reprises de contacts via des plots de contact n-Pad pour connecter le substrat dopé n permettant de définir un contact inférieur et des reprises de contacts via des plots de contact p-Pad pour connecter la couche dopée p en InGaAs, permettant de définir un contact supérieur.

Le document US6596616 décrit une structure semiconductrice avec des contacts métalliques sur matériaux III-V qui est spécifiquement adaptée pour réduire la résistance de contact associée aux contacts sur matériaux III-V en augmentant la surface effective (surface d'échange électrique) de contact entre le contact ohmique et la couche semiconductrice.

Dans ce contexte, la présente invention propose un procédé permettant de réaliser des contacts sur matériaux III-V compatibles notamment avec la filière silicium permettant ainsi une co-intégration matériaux III-V/Silicium sur une plateforme traitant des plaques de 100 mm de diamètre au minimum.

Cette invention ouvre ainsi la voie à un produit fini intégré dans une salle blanche compatible silicium traitant des plaques de 100 mm ou plus, compact et présentant au moins deux niveaux de contacts planaires réalisés simultanément ou séquentiellement.

Plus précisément, la présente invention a pour objet un procédé de réalisation d'un composant comprenant une structure en matériau(x) III-V à la surface d'un substrat, ladite structure comprenant au moins un niveau supérieur de contact défini à la surface d'un premier matériau III-V et un niveau inférieur de contact défini à la surface d'un second matériau III-V, ledit niveau inférieur de contact étant inférieur audit niveau supérieur de contact, le procédé comportant :- l'encapsulation par au moins un diélectrique de ladite structure
- la réalisation dans ledit diélectrique d'au moins une ouverture supérieure primaire à la surface dudit premier matériau III-V et d'au moins une ouverture inférieure primaire à la surface dudit second matériau III-V de manière à définir des zones de fond de contact sur ledit premier matériau III-V et sur ledit second matériau III-V ;
- la réalisation de métallisations de fond de contact dans ladite au moins ouverture supérieure primaire et dans ladite au moins ouverture inférieure primaire, de manière à former une structure intermédiaire;
- l'encapsulation de la structure intermédiaire par au moins un diélectrique de ladite au moins ouverture supérieure primaire et de ladite au moins ouverture inférieure primaire;
- la réalisation d'au moins une ouverture supérieure secondaire dans le diélectrique situé dans ladite au moins ouverture supérieure primaire, et la réalisation d'au moins une ouverture inférieure secondaire dans le diélectrique situé dans ladite ouverture inférieure primaire;
- le remplissage de ladite au moins ouverture supérieure secondaire et de ladite au moins ouverture inférieure secondaire par au moins une matière métallique de manière à réaliser au moins un plot de contact supérieur sur une surface de métallisation de fond de contact inférieure à la surface de la métallisation de fond de contact déposée dans ladite au moins ouverture supérieure primaire et au moins un plot de contact inférieur sur une surface de métallisation de fond de contact inférieure à la surface de la métallisation de fond de contact déposée dans ladite au moins ouverture inférieure primaire ;
- les métallisations de fond de contact et les plots de contact définissant au moins un contact supérieur dudit premier matériau III-V en contact avec ledit niveau supérieur de contact et au moins un contact inférieur dudit second matériau III-V en contact avec ledit niveau inférieur de contact;
- au moins ledit contact supérieur et au moins ledit contact inférieur sont partiellement intégrés dans du diélectrique et présentent une surface supérieure non recouverte par le diélectrique et définie dans un même plan ;
- les métallisations de fond de contact, étant de nature différente de celle de la matière métallique;
- ladite structure présentant une base inférieure en second matériau III-V et une mesa en premier matériau III-V située au dessus de ladite base

On définit le caractère planaire comme étant l'ensemble des contacts émergeants sur un même plan.

On définit ainsi dans la présente demande de brevet :
- un contact supérieur à partir d'une ouverture supérieure comportant une métallisation de fond de contact et un plot de contact ;
- un contact inférieur à partir d'une ouverture inférieure comportant une métallisation de fond de contact et un plot de contact.

Pour aboutir à ce résultat, les contacts inférieurs (pour la partie remplissage) peuvent être réalisés en une ou plusieurs étapes.

Pour cela une ouverture inférieure peut être réalisée en deux opérations successives définissant une première ouverture inférieure et une seconde ouverture supérieure, comme il sera développé dans la description détaillée de l'invention.

On définit par matière métallique :
- les métaux purs, les alliages de métaux, les alliages métal + élément non métallique ;
- les composés intermétalliques ou métalloïdes (différent d'un alliage dans sa construction cristallographique).

L'intégration de type planaire ouvre la voie à une intégration 3D, par le biais d'un collage hybride ou direct (par exemple photonique / électronique) ou du report de puces par le biais de bumps.

Dans le cadre d'une co-intégration III-V/Si, la réalisation d'un back-end (correspondant à l'ensemble des étapes constituant les interconnexions par liaisons métalliques) planarisé permet également d'envisager la reprise de contact sur les dispositifs des niveaux inférieurs (back-end front side ou intermétallique par exemple).

Selon des variantes de l'invention, la structure présente une base inférieure en second matériau III-V et une mesa en premier matériau III-V située au dessus de ladite base.

Selon la présente invention, il peut être prévu de réaliser des contacts sur les deux matériaux III-V en réalisant des ouvertures dites primaires dans lesquelles on vient réaliser des métallisations de fond de contact en fond d'ouvertures, puis en définissant des ouvertures secondaires après remplissage par du diélectrique, pour réaliser des plots de contacts, plusieurs plots de contact contactant ainsi une même métallisation de fond de contact préalablement définie dans une ouverture primaire.

Selon des variantes de l'invention, le procédé comprend la réalisation successive d'au moins une ouverture supérieure primaire et d'au moins une ouverture inférieure primaire.

Il peut être intéressant d'optimiser indépendamment les métallisations de contact sur chacun des matériaux présents dans le composant III-V afin de minimiser les résistances de contact associées.

Selon des variantes de l'invention, le procédé comprend la réalisation simultanée d'au moins une ouverture supérieure secondaire et d'au moins une ouverture inférieure secondaire.

Selon des variantes de l'invention, le procédé comporte :
- l'encapsulation par du diélectrique d'un ensemble comprenant le premier matériau III-V recouvert d'une métallisation et le second matériau III-V recouvert d'une métallisation ;
- la réalisation d'au moins une ouverture inférieure secondaire en regard du second matériau III-V ;
- la réalisation d'au moins une ouverture supérieure secondaire au dessus dudit premier matériau III-V et la réalisation d'au moins une ouverture inférieure secondaire supplémentaire au dessus d'au moins ladite ouverture inférieure secondaire ;
- le remplissage d'au moins ladite ouverture supérieure secondaire, d'au moins une ouverture inférieure secondaire supplémentaire et d'au moins ladite ouverture inférieure secondaire.

Selon des variantes de l'invention, la structure comprenant au moins un matériau III-V dit supérieur, un matériau III-V dit intermédiaire, un matériau III-V dit inférieur, le procédé comprend :
- la réalisation d'au moins une ouverture supérieure primaire, d'au moins une ouverture intermédiaire primaire, d'au moins une ouverture inférieure primaire ;
- la réalisation d'au moins une ouverture supérieure secondaire, d'au moins une ouverture intermédiaire secondaire et d'au moins une ouverture inférieure secondaire ;
- le remplissage desdites ouvertures.

Selon des variantes de l'invention :
- au moins ladite ouverture inférieure secondaire comporte trois portions de dimensions différentes ;
- au moins ladite ouverture intermédiaire secondaire comporte deux portions de dimensions différentes ;
- au moins ladite ouverture supérieure secondaire comporte une portion.

Selon des variantes de l'invention, le procédé comprend les étapes suivantes :
- l'encapsulation de ladite structure par un premier diélectrique ;
- la réalisation d'au moins une ouverture inférieure primaire débouchant sur ledit second matériau III-V ;
- le dépôt de métallisation à la surface dudit premier diélectrique et à la surface dudit second matériau semiconducteur définissant une métallisation de contact inférieur et un premier ensemble ;
- l'encapsulation dudit premier ensemble par un second diélectrique ;
- la planarisation dudit premier ensemble encapsulé ;
- la réalisation d'au moins une ouverture inférieure secondaire débouchant sur ladite métallisation de fond de contact inférieur ;
- le remplissage par au moins une matière métallique de ladite au moins ouverture inférieure secondaire définissant au moins un plot de contact dudit contact inférieur et un second ensemble ;
- l'encapsulation dudit second ensemble par un troisième diélectrique ;
- la réalisation d'au moins une ouverture supérieure primaire au dessus dudit premier matériau III-V ;
- le dépôt de métallisation à la surface dudit troisième matériau diélectrique et de ladite ouverture supérieure définissant une métallisation de fond de contact supérieur et un troisième ensemble ;
- l'encapsulation dudit troisième ensemble par un quatrième diélectrique ;
- la planarisation dudit troisième ensemble ;
- la réalisation d'au moins une ouverture supérieure secondaire au dessus de ladite métallisation de fond de contact supérieur et au moins une ouverture supérieure au dessus au moins dudit plot de contact dudit contact inférieur ;
- le remplissage par au moins une matière métallique de ladite au moins ouverture supérieure secondaire au dessus de ladite métallisation de fond de contact supérieur et de ladite au moins ouverture supérieure au dessus au moins dudit plot de contact dudit contact inférieur, définissant au moins un plot supérieur de contact supérieur et au moins une prolongement de plot de contact inférieur, ledit contact supérieur et au moins ledit contact inférieur présentant une surface définie dans un même plan.

Selon des variantes, le procédé comporte les étapes suivantes :
- l'encapsulation de ladite structure par un premier diélectrique ;
- la réalisation d'au moins une ouverture supérieure primaire débouchante sur ledit premier matériau III-V ;
- le dépôt de métallisation à la surface dudit premier diélectrique et à la surface dudit premier matériau semiconducteur définissant une métallisation de contact supérieur et un premier ensemble ;
- l'encapsulation dudit premier ensemble par un second diélectrique ;
- la planarisation dudit premier ensemble encapsulé ;
- la réalisation d'au moins une ouverture supérieure secondaire débouchant sur ladite métallisation de fond de contact supérieur ;
- le remplissage par au moins une matière métallique de ladite au moins ouverture supérieure secondaire définissant au moins un plot de contact dudit contact supérieur et un second ensemble ;
- la réalisation d'au moins une ouverture inférieure primaire au dessus dudit second matériau III-V;
- le dépôt de métallisation à la surface dudit premier matériau diélectrique et de ladite ouverture inférieure primaire définissant une métallisation de contact inférieur et un troisième ensemble ;
- l'encapsulation dudit troisième ensemble par un quatrième diélectrique ;
- la planarisation dudit troisième ;
- la réalisation d'au moins une ouverture inférieure secondaire au dessus de ladite couche de fond de contact inférieur;
- le remplissage par au moins une matière métallique de ladite au moins ouverture inférieure secondaire, définissant au moins un plot de contact inférieur, ledit contact supérieur et au moins ledit contact inférieur présentant une surface définie dans un même plan.

Selon des variantes, le procédé comprend :
- la réalisation simultanée d'au moins une ouverture supérieure primaire et d'au moins une ouverture inférieure primaire ;
- la réalisation simultanée d'au moins une ouverture supérieure secondaire et d'au moins une ouverture inférieure secondaire.

Selon des variantes de l'invention, le procédé comprend la réalisation d'un niveau supplémentaire de contact à la surface desdits contacts planaires, comportant :
- un dépôt supplémentaire de diélectrique ;
- la réalisation d'au moins une ouverture supplémentaire inférieure et d'au moins une ouverture supplémentaire supérieure ;
- le remplissage desdites ouvertures supplémentaires par au moins une matière métallique pour définir au moins un contact supplémentaire inférieur et au moins un contact supplémentaire supérieur.

Selon des variantes de l'invention, le procédé comporte la réalisation d'ouvertures inférieures primaires présentant une largeur comprise entre 20 µm et 50 µm et la réalisation d'ouvertures inférieures secondaires présentant une largeur comprise entre 0,5 µm et 5 µm, préférentiellement comprise entre 1 µm et 3 µm.

Selon des variantes de l'invention, le premier matériau III-V et le second matériau III-V sont choisis parmi :
Le premier matériau III-V peut être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As.

Le second matériau III-V peut également être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As...

Selon des variantes de l'invention le substrat est en silicium.

Selon des variantes de l'invention, le ou les diélectriques sont choisis parmi : SiN, SiO2, Al2O3, un polymère planarisant pouvant être à base de Benzocyclobutène (BCB) ou SOG.

Selon des variantes de l'invention, on réalise le dépôt d'un métal tel que Ni₂P, Ni₃P, NiGe, TiP, TiGe dans lesdites ouvertures primaires.

Selon des variantes de l'invention, on réalise le dépôt d'un métal tel que Ni, Ti et alliage comme NiPt, NiTi, NiCo dans lesdites ouvertures primaires.

Selon des variantes de l'invention, les opérations de remplissage comprennent :
- le dépôt d'une barrière de diffusion pouvant être composée d'une ou plusieurs couches de matériau choisi parmi : TiN, Ti/TiN, TaN, Ta/TaN, W (sans fluor) ;
- le dépôt d'un métal de remplissage choisi parmi : W, Cu, Al, AlCu, AlSi.

Concernant la barrière de diffusion, W est sans fluor car la barrière est déposée par CVD (voie chimique) dont le précurseur ne contient pas de F contrairement au W de remplissage. Le F étant néfaste pour les dispositifs c'est pour cela qu'une barrière est utilisée. Cette barrière peut servir également à faciliter la nucléation du métal de remplissage (W, Cu, Al...).

L'élément W est particulièrement intéressant dans le cadre de la présente invention car assez peu résistif et facile de mise en oeuvre, il peut ainsi être avantageusement utilisé pour remplir les ouvertures secondaires.

Selon des variantes de l'invention, le dépôt de métallisation est suivi d'un traitement thermique ayant pour but de former un ou plusieurs composé(s) intermétallique(s).

Selon des variantes de l'invention, le composant étant un laser, le procédé de l'invention comprend une opération pour réaliser un guide en matériau semiconducteur pouvant être du Si, dans un substrat diélectrique pouvant être en SiO₂.

Selon des variantes de l'invention, le composant étant un laser, le procédé de l'invention comprend la réalisation d'un contact supérieur circulaire pour permettre l'émission verticale du rayonnement laser.

L' invention a encore pour objet le composant obtenu selon le procédé de l'invention.

Le composant peut être un laser à émission par la tranche, ou à émission verticale. Il peut également s'agir avantageusement d'un composant comprenant une série de matériaux III-V différents présentant des longueurs d'onde d'absorption différentes pour élargir la bande d'absorption du composant.

La présente invention peut s'appliquer à une multitude de configurations de départ, telles que :
- des reports III-V sur tout type de substrat par exemple sur Si puces à plaques ;
- des plaques à plaques ;
- des épitaxies de III-V sur substrat Si, III-V, ou tout substrat définitif ou temporaire permettant la croissance cristalline de III/V. Il est à noter qu'il convient d'avoir au moins un germe cristallin de structure cristallographique identique à celui du matériau III/V que l'on veut faire croitre et des paramètres de maille proches de la couche en croissance. Au-delà de 5% de différence entre les paramètres de maille, le cristal est défectueux (dislocation, joint d'antiphase voire polycristallin). Ceci est impossible sur substrat amorphe type verre.

Les substrats de départ peuvent être de diamètre 100 mm ou plus.

L'invention sera mieux comprise et d'autres avantages apparaîtront à la lecture de la description qui va suivre donnée à titre non limitatif et grâce aux figures annexées parmi lesquelles :
- la figure 1 illustre un exemple de composant à base de matériaux III-V de l'art antérieur ;
- la figure 2 illustre un exemple de structure de matériaux III-V sur substrat employée dans des exemples de procédé de l'invention ;
- la figure 3 illustre un premier exemple de composant réalisé dans le cadre d'une première alternative qui n'est pas un mode de réalisation de l'invention ;
- les figures 4a à 4i illustrent les différentes étapes d'un premier exemple de procédé selon la première alternative et comprenant la réalisation des contacts inférieurs puis celle des contacts supérieurs réalisés sur des métallisations de fond de contact individuelles ;
- les figures 5a à 5h illustrent les différentes étapes d'un second exemple de procédé selon la première alternative et comprenant la réalisation des contacts supérieurs puis celle des contacts inférieurs réalisés sur des métallisations de fond de contact individuelles ;
- les figures 6a à 6e illustrent les différentes étapes d'un troisième exemple de procédé selon la première alternative et comprenant la réalisation des contacts inférieurs simultanée à celle des contacts supérieurs réalisés sur des métallisations de fonds de contacts individuelles ;
- les figures 7f à 7k illustrent des variantes d'étapes à celles de la réalisation des plots de contact inférieurs illustrés en figures 4a à 4i permettant de ne pas avoir une couche d'interface métallique dans lesdits plots de contact inférieurs ;
- les figures 8b à 8e illustrent des étapes de procédé constituant une variante aux étapes de réalisation des plots de contact en double damascène ;
- la figure 9 illustre une étape d'intégration d'un niveau supplémentaire de contact pouvant être utilisé dans des variantes de procédé selon la première alternative qui n'est pas un mode de réalisation de l'invention;
- la figure 10 illustre un premier exemple de composant laser réalisé selon le procédé selon la première alternative qui n'est pas un mode de réalisation de l'invention :
- la figure 11 illustre un second exemple de composant laser réalisé selon le procédé selon la première alternative qui n'est pas un mode de réalisation de l'invention ;
- la figure 12 illustre un premier exemple de composant réalisé dans le cadre de la présente invention et comprenant des métallisations de fond de contact partagées entre plusieurs plots ;
- les figures 13a à 13o illustrent les différentes étapes d'un premier exemple de procédé réalisé dans le cadre de la de l'invention comprenant la réalisation des contacts inférieurs puis celle des contacts supérieurs et comprenant des ouvertures supérieures secondaires et des ouvertures inférieures secondaires ;
- les figures 14a à 14n illustrent les différentes étapes d'un deuxième exemple de procédé de l'invention réalisé dans le cadre de la présente invention comprenant la réalisation des contacts supérieurs puis celle des contacts inférieurs ;
- les figures 15a à 15h illustrent les différentes étapes d'un troisième exemple de procédé réalisé dans le cadre de l'invention comprenant la réalisation simultanée des contacts inférieurs et supérieur ;
- les figures 16a à 16d illustrent les différentes étapes d'un quatrième exemple de procédé de l'invention comprenant la réalisation simultanée d'ouvertures supérieures et inférieures secondaires à double niveau dans le cadre de l'invention ;
- la figure 17 illustre une étape d'intégration d'un niveau supplémentaire de contact pouvant être utilisé dans des variantes de procédé de l'invention ;
- la figure 18 illustre un premier exemple de composant laser réalisé selon le procédé de l'invention :
- la figure 19 illustre un second exemple de composant laser réalisé selon le procédé de l'invention ;
- la figure 20 illustre un exemple de composant obtenu selon le procédé de l'invention dans cadre d'une intégration photonique ;
- la figure 21 illustre un exemple de composant absorbant dans différentes gammes de longueur d'onde grâce à l'utilisation d'au moins trois niveaux de matériaux III-V différents, et réalisé selon le procédé de l'invention ;
- la figure 22 illustre un exemple de composant qui n'est pas un mode de réalisation de l'invention dans lequel les contacts sont repris sur une cellule solaire dans laquelle la multiplication et la diversification des matériaux III-V donne accès à une plus large bande d'absorption ;
- les figures 23a et 23b schématisent deux vues de contacts et les lignes de champ électrique permettant d'illustrer les longueurs de transfert ;
- la figure 24 illustre une représentation schématique d'une structure TLM ;
- la figure 25 illustre l'évolution de la résistance totale mesurée en fonction de l'espacement entre contacts dans le cas d'une structure TLM.

Dans la description détaillée ci-après décrit différents modes de réalisation de l'invention sont décrits.

L'intégration des contacts est présentée sur deux niveaux mais est applicable à une multitude de niveaux présentant entre eux une topographie de niveaux de contacts différents au niveau des matériaux III-V.

L'invention est décrite ci-après dans le cadre d'un substrat **9** sur lequel est réalisée une structure comprenant un matériau III-V de base **2** et un matériau III-V supérieur **1** comme illustré en figure 2, dans lequel on pourra réaliser une mesa présentant une surface inférieure à celle matériau III-V de base.

Dans l'ensemble de la description on référence ci-après :
- un premier matériau III-V : **1** ;
- un second matériau III-V : **2** ;
- un substrat : **9** ;
- un ou plusieurs matériau(x) diélectrique(s) : **8** ;
- une métallisation : **3** ;
- une barrière de diffusion : **4** ;
- un matériau de remplissage métallique : **5** ;
- des ouvertures supérieures **Os** en contact avec le premier matériau 1 ;
- des ouvertures inférieures **Oi** en contact avec le second matériau 2 .

Un contact supérieur **Cₛᵤₚ** est défini à partir d'au moins une ouverture supérieure **Oₛ** ou à partir d'au moins une ouverture supérieure primaire **Oₛₚ** et à partir d'au moins une ouverture supérieure secondaire **Oₛₛ**.

Un contact inférieur **C_{inf}** est défini à partir d'au moins une ouverture inférieure **Oₗ** ou à partir d'au moins une ouverture inférieure primaire **Oᵢₚ** et d'au moins une ouverture inférieure secondaire **Oᵢₛ**.

Un contact intermédiaire **Cᵢₙₜ** est défini à partir d'au moins une ouverture intermédiaire primaire **Oₜₚ** et à partir d'au moins une ouverture intermédiaire secondaire **Oₜₛ**.

La figure 3 montre un exemple de composant obtenu selon un procédé selon une première alternative donnée à titre d'exemple et qui n'est pas un mode de réalisation de l'invention l'invention. Cette première alternative met en évidence, sur un substrat **9**, les matériaux III-V **1** et **2**, des métallisations **3** servant de métallisations de fond de contact, sur lesquelles sont réalisés des plots de contact comprenant des barrières de diffusion **4,** les ouvertures secondaires sont remplies de métal de remplissage **5.** L'ensemble est encapsulé dans un diélectrique **8.** La figure 3 met en évidence les niveaux de contact : un niveau inférieur **N_{inf}**, un niveau supérieur **Nₛᵤₚ**. Selon cet exemple, il peut être prévu un niveau supplémentaire **N_{sup/supl}** sur lequel peuvent être réalisés des plots de contact remplis de barrière de diffusion **7** et de métal de remplissage **6.**

Le premier matériau III-V peut être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As.

Le second matériau III-V peut également être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}A. Il peut être identique au premier matériau ou différent de ce dernier.

Le substrat peut être un substrat en silicium pouvant par exemple présenter une épaisseur de l'ordre de quelques centaines de millimètres (par exemple 200 mm).

Tout comme illustré dans la figure 3, selon la présente invention, les niveaux supérieurs des contacts supérieur(s) et inférieur(s) sont situés dans un même plan.

L'ensemble des figures montrent des vues en coupe de contacts pouvant être circulaires ou linéaires.

### I) Première alternative comportant la réalisation d'un type d'ouvertures dédiées à recevoir une métallisation de fond de contact et des plots de contacts en contact avec ladite métallisation de fond de contact.

### Premier exemple de procédé comprenant la réalisation de contacts inférieurs suivie de celle de contact supérieur selon la première alternative

### Première étape :

On procède à l'encapsulation de la structure préalablement réalisée et comportant une mesa en un premier matériau III-V **1** à la surface d'une base en un matériau III-V **2** sur un substrat **9.**

Le (les) diélectriques **8** utilisés peuvent être : SiN, SiO₂, Al₂O₃, polymère de type planarisant par exemple à base de benzocyclobutane (BCB), ou de type: SOG « Spin-On-Glass » : dépôt de diélectrique amorphe par centrifugation.

Le dépôt peut être monocouche ou multicouches.

Les diélectriques sont déposés par PVD (dépôt physique en phase vapeur), CVD (dépôt chimique en phase vapeur) et/ou ALD (dépôt de couches minces atomique. Typiquement la température de dépôt peut être ≤ 550 °C, préférentiellement ≤ 450 °C.

Le stress des couches réalisées peut avantageusement être ≤ 200 MPa, préférentiellement ≤ 100 MPa.

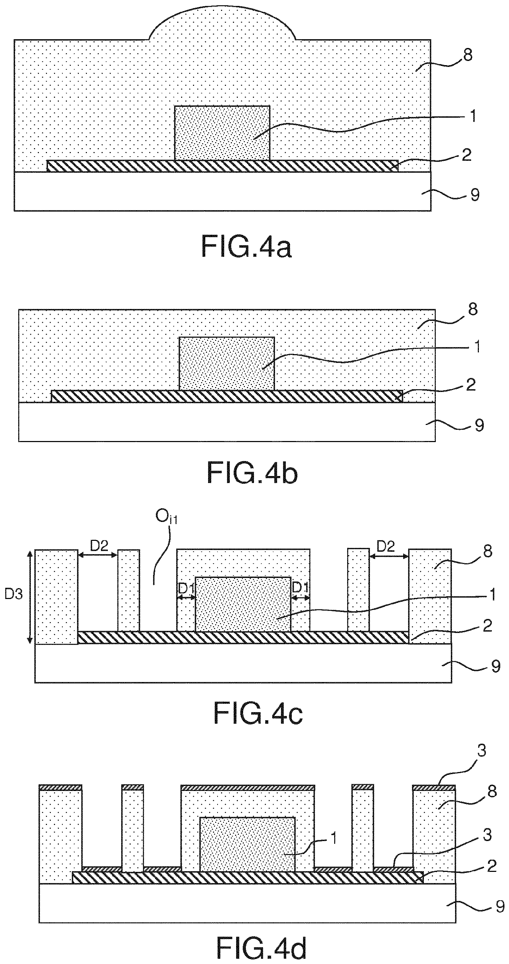

La figure 4a illustre cette étape d'encapsulation.

### Deuxième étape :

On procède à la planarisation du diélectrique par une opération de CMP pour *"chemical mechanical planarization"* ou *"chemical mechanical polishing"* (planarisation ou polissage mécano chimique) ou de retrait partiel par gravure sèche « *etch back* » dans le cas d'un polymère planarisant

Il existe certains polymères qui ont la propriété d'être auto-nivellant. C'est-à-dire qu'ils vont remplir en premier lieu les parties inférieures avant les parties supérieures. Mais pour être assuré de remplir les cavités entièrement le dépôt est plus épais que la profondeur de la cavité. Il convient ensuite de diminuer l'épaisseur du surplus de dépôt. Cela peut être fait par une gravure sèche sur l'ensemble de la plaque appelée « *etch back ».*

Il est possible également d'utiliser une opération de lithographie / gravure localisée sur la topographie avant CMP.

La figure 4b illustre cette étape de planarisation.

### Troisième étape :

On procède à la réalisation de premières ouvertures inférieures **Oᵢ₁** dédiées au contact inférieur.

Typiquement les dimensions D1 et D2 peuvent être les suivantes :
La dimension D1 (largeur de diélectrique de part et d'autre de la mesa en matériau III-V **1**) est au minimum de 200 nm et préférentiellement comprise entre 2 et 3 µm.

La dimension D2 (largeur des ouvertures inférieures) peut être comprise entre 0,5 et 10 µm et préférentiellement comprise entre 1 et 5 µm

La dimension D3 (épaisseur de diélectrique) est comprise entre 0,5 µm et 5 µm, préférentiellement entre 5 et 3 µm.

Ces ouvertures peuvent être réalisées par gravure sèche. Dans ce cas, la présence d'une couche d'arrêt à la gravure est optionnelle.

On peut aussi opérer par gravure séquentielles :
une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau 2.

Cette (ces) gravure(s) peut (peuvent) être réalisée(s) directement via la résine utilisée pour la photolithographie ou préférentiellement à l'aide d'un masque dur composé par exemple de SiN.

### Quatrième étape :

On procède au dépôt d'une métallisation compatible avec une filière silicium pour définir le contact inférieur permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C

La température de recuit est préférentiellement ≤ 450 °C

Selon l'option 1, on dépose le métal ou le composé intermétallique et on utilise le travail de sortie de ce dernier. Dans ce cas le recuit sert à guérir les défauts d'interface et cristalliser le métal ou le composé.

Selon l'option 2, on dépose le métal, on le fait réagir pour former le composé intermétallique ayant le travail de sortie visé. Dans ce cas le recuit sert à la réaction à l'état solide.

Un retrait sélectif du métal n'ayant pas réagi peut-être réalisé après traitement thermique.

L'ensemble de ces étapes est illustré en figure 4d.

### Cinquième étape :

On procède au remplissage des premières ouvertures inférieures et opération de CMP pour réaliser des plots de connexion. Le remplissage des ouvertures inférieures est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

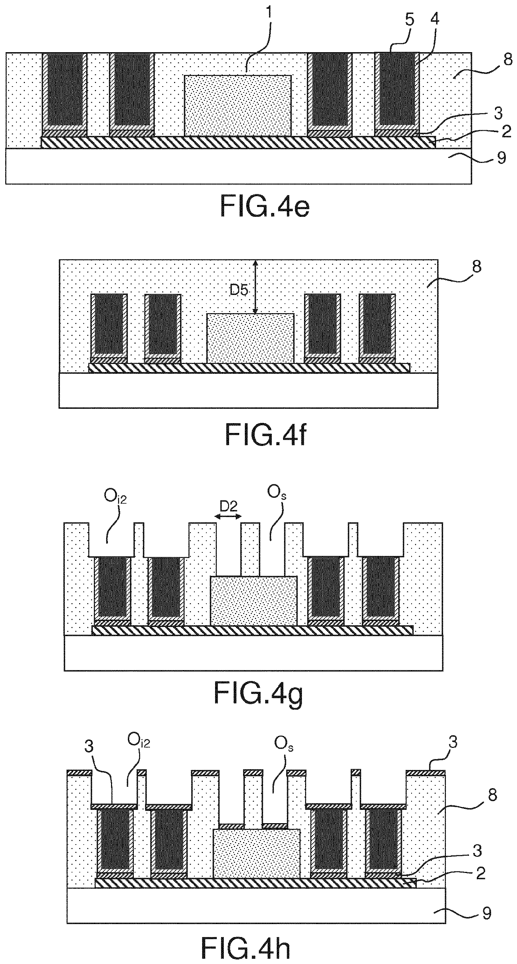

L'ensemble de ces étapes est illustré en figure 4e.

### Sixième étape :

On procède à une étape d'encapsulation de l'ensemble défini précédemment par du diélectrique **8.** L'épaisseur **D5** du diélectrique au dessus du matériau **1** peut typiquement être comprise entre 200nm et 1 µm et de préférence comprise entre 200nm et 500 nm. Le (les) diélectrique(s) utilisés peuvent être: SiN, SiO₂, Al₂O₃, polymère de type planarisant (par exemple BCB, SOG). Le dépôt peut être monocouche ou multicouches. Ils sont déposés par PVD, CVD et/ou ALD ;

La température de dépôt est ≤ 450 °C, préférentiellement ≤ 300 °C.

Cette étape est illustrée en figure 4f.

Les opérations de stabilisation des phases ou de traitement thermique pour former un ou plusieurs composé(s) intermétallique(s) peuvent être réalisées à l'issue de cette étape, si elles n'ont pas été réalisées préalablement.

### Septième étape :

On procède à la réalisation de secondes ouvertures inférieures **Oᵢ₂** dédiées au contact inférieur et à des ouvertures **Oₛ** dédiées au contact supérieur.

Ces ouvertures peuvent être réalisées par gravure sèche. Dans ce cas, la présence d'une couche d'arrêt à la gravure est optionnelle.

On peut aussi opérer par gravure séquentielles : une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau **1.**

Cette (ces) gravure(s) peut (peuvent) être réalisée(s) directement via la résine utilisée pour la photolithographie ou préférentiellement à l'aide d'un masque dur composé par exemple de SiN.

La dimension D2 (largeur des ouvertures supérieures) peut être comprise entre 0,5 et 10 µm et préférentiellement comprise entre 1 et 5 µm.

Cette étape est illustrée en figure 4g.

### Huitième étape :

On procède au dépôt d'une métallisation compatible avec une filière silicium pour définir les contacts inférieurs et le contact supérieur permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C

La température de recuit est préférentiellement ≤ 450 °C

Selon l'option 1, on dépose le métal ou le composé intermétallique et on utilise le travail de sortie de ce dernier. Dans ce cas le recuit sert à guérir les défauts d'interface et cristalliser le métal ou le composé.

Cette étape est illustrée en figure 4h.

### Neuvième étape :

On procède au remplissage des ouvertures inférieures et des ouvertures supérieures et opération de CMP pour réaliser des plots de connexion. Le remplissage des ouvertures inférieures et des ouvertures supérieures est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

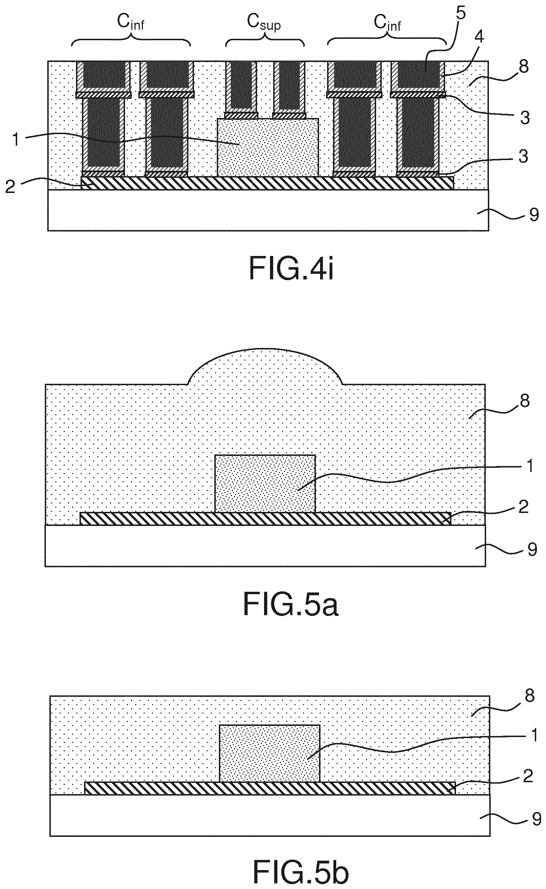

L'ensemble de ces étapes est illustré en figure 4i, mettant en évidence le contact supérieur **Cₛᵤₚ** et deux niveaux de métallisations **3** dans les contacts inférieurs **C_{inf}**.

Une alternative au mode de réalisation décrit dans ce premier exemple consiste à définir séquentiellement les cavités de contacts décrites en figures 4c-4d puis en figures 4g-4h mais à définir les cavités plots décrites en figures 4e et 4i en une seule étape.

### Second exemple de procédé comprenant la réalisation de contacts supérieurs suivie de celle de contacts inférieurs selon la première alternative:

### Première étape :

On procède à l'encapsulation de la structure préalablement réalisée et comportant une mesa en un premier matériau III-V **1** à la surface d'une base en un matériau III-V **2** sur un substrat **9.**

Le (les) diélectriques **8** utilisés peuvent être : SiN, SiO₂, Al₂O₃, polymère de type planarisant par exemple à base de benzocyclobutane (BCB), ou de type: SOG « Spin-On-Glass » : dépôt de diélectrique amorphe par centrifugation.

Le dépôt peut être monocouche ou multicouches.

Les diélectriques sont déposés par PVD (dépôt physique en phase vapeur), CVD (dépôt chimique en phase vapeur) et/ou ALD (dépôt de couches minces atomique. Typiquement la température de dépôt peut être ≤ 550 °C, préférentiellement ≤ 450 °C.

Le stress des couches réalisées peut avantageusement être ≤ 200 MPa, préférentiellement ≤ 100 MPa.

La figure 5a illustre cette étape d'encapsulation.

### Deuxième étape :

On procède à la planarisation du diélectrique par une opération de CMP pour *"chemical mechanical planarization"* ou *"chemical mechanical polishing"* (planarisation ou polissage mécano chimique) ou de retrait partiel par gravure sèche « *etch back* » dans le cas d'un polymère planarisant.

Il existe certains polymères qui ont la propriété d'être auto-nivellant. C'est-à-dire qu'ils vont remplir en premier lieu les parties inférieures avant les parties supérieures. Mais pour être assuré de remplir les cavités entièrement le dépôt est plus épais que la profondeur de la cavité. Il convient ensuite de diminuer l'épaisseur du surplus de dépôt. Cela peut être fait par une gravure sèche sur l'ensemble de la plaque appelée « *etch back ».*

Il est possible également d'utiliser une opération de lithographie / gravure localisée sur la topographie avant CMP .

La figure 5b illustre cette étape de planarisation.

### Troisième étape :

On procède à la réalisation d'ouvertures supérieure **Oₛ** dédiées au contact supérieur.

Ces ouvertures peuvent être réalisées par gravure sèche. Dans ce cas, la présence d'une couche d'arrêt à la gravure est optionnelle.

On peut aussi opérer par gravure séquentielles :
une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau **1.**

Cette (ces) gravure(s) peut (peuvent) être réalisée(s) directement via la résine utilisée pour la photolithographie ou préférentiellement à l'aide d'un masque dur composé par exemple de SiN.

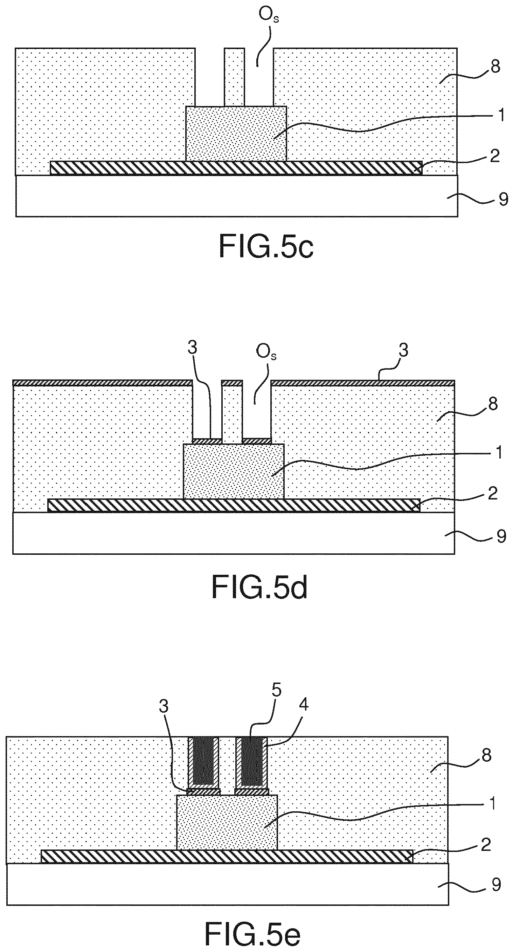

La figure 5c illustre cette étape de réalisation d'ouvertures.

### Quatrième étape :

On procède au dépôt d'une métallisation compatible avec une filière silicium pour définir le contact supérieur permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C

La température de recuit est préférentiellement ≤ 450 °C

Selon l'option 1, on dépose le métal ou le composé intermétallique et on utilise le travail de sortie de ce dernier. Dans ce cas le recuit sert à guérir les défauts d'interface et cristalliser le métal ou le composé.

Cette étape est illustrée en figure 5d.

### Cinquième étape :

On procède au remplissage des ouvertures supérieures et opération de CMP pour réaliser des plots de connexion. Le remplissage des ouvertures supérieures est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

L'ensemble de ces étapes est illustré en figure 5e, mettant en évidence deux niveaux de métallisations **3** dans les contacts supérieurs.

### Sixième étape :

On procède à la réalisation d'ouvertures inférieures **Oᵢ** dédiées au contacts inférieurs.

Ces ouvertures peuvent être réalisées par gravure sèche. Dans ce cas, la présence d'une couche d'arrêt à la gravure est optionnelle.

On peut aussi opérer par gravure séquentielles :
une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau **2.**

Cette (ces) gravure(s) peut (peuvent) être réalisée(s) directement via la résine utilisée pour la photolithographie ou préférentiellement à l'aide d'un masque dur composé par exemple de SiN.

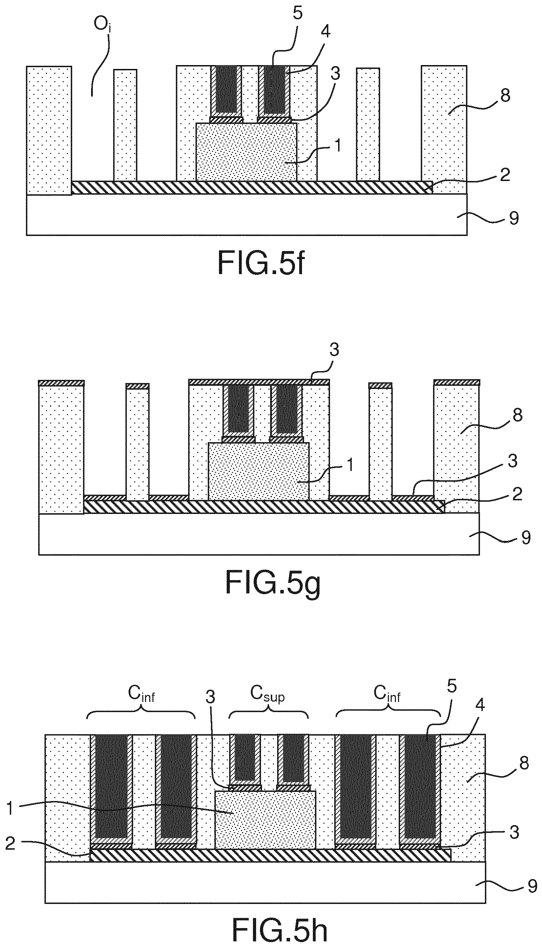

La figure 5f illustre cette étape de réalisation d'ouvertures.

### Septième étape :

On procède au dépôt d'une métallisation compatible avec une filière silicium pour définir les contacts inférieurs permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C

La température de recuit est préférentiellement ≤ 450 °C

Selon l'option 1, on dépose le métal ou le composé intermétallique et on utilise le travail de sortie de ce dernier. Dans ce cas le recuit sert à guérir les défauts d'interface et cristalliser le métal ou le composé.

Cette étape est illustrée en figure 5g.

### Huitième étape :

On procède au remplissage des ouvertures inférieures et opération de CMP pour réaliser des plots de connexion. Le remplissage des ouvertures inférieures est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

L'ensemble de ces opérations est illustré en figure 5h, mettant en évidence deux niveaux de métallisations **3** dans les contacts inférieurs.

Une alternative au mode décrit dans ce second exemple consiste à ouvrir séquentiellement les cavités de contacts décrites en figures 5c-5d puis en figures 5f-5g mais à ouvrir les cavités plots décrites en figures 5e et 5h en une seule étape.

### Troisième exemple de procédé comprenant la réalisation simultanée de contacts supérieurs et de contacts inférieurs selon la première alternative:

### Première étape :

On procède à l'encapsulation de la structure préalablement réalisée et comportant une mesa en un premier matériau III-V **1** à la surface d'une base en un matériau III-V **2** sur un substrat **9.**

Le (les) diélectriques **8** utilisés peuvent être : SiN, SiO₂, Al₂O₃, polymère de type planarisant par exemple à base de benzocyclobutane (BCB), ou de type: SOG « Spin-On-Glass » : dépôt de diélectrique amorphe par centrifugation.

Le dépôt peut être monocouche ou multicouches.

Les diélectriques sont déposés par PVD (dépôt physique en phase vapeur), CVD (dépôt chimique en phase vapeur) et/ou ALD (dépôt de couches minces atomique. Typiquement la température de dépôt peut être ≤ 550 °C, préférentiellement ≤ 450 °C.

Le stress des couches réalisées peut avantageusement être ≤ 200 MPa, préférentiellement ≤ 100 MPa.

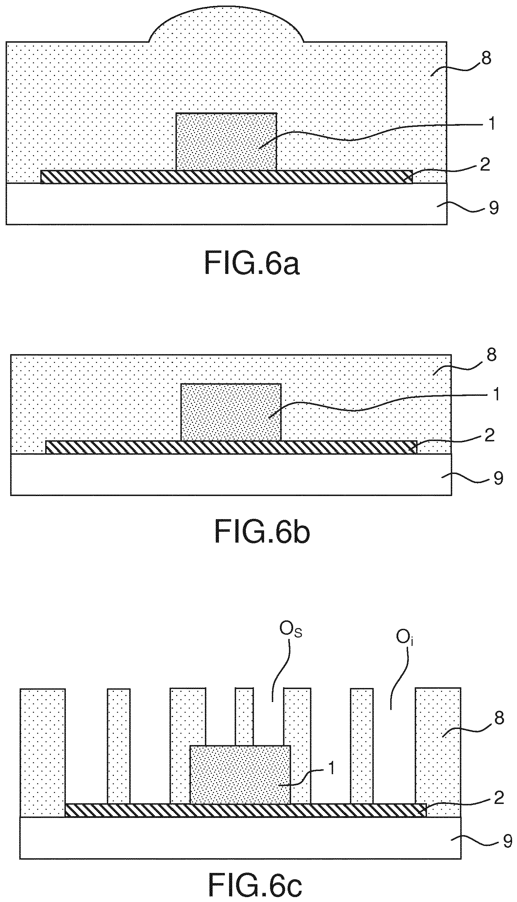

La figure 6a illustre cette étape d'encapsulation.

### Deuxième étape :

On procède à la planarisation du diélectrique par une opération de CMP pour *"chemical mechanical planarization"* ou *"chemical mechanical polishing"* (planarisation ou polissage mécano chimique) ou de retrait partiel par gravure sèche « *etch back* » dans le cas d'un polymère planarisant.

Il existe certains polymères qui ont la propriété d'être auto-nivellant. C'est-à-dire qu'ils vont remplir en premier lieu les parties inférieures avant les parties supérieures. Mais pour être assuré de remplir les cavités entièrement le dépôt est plus épais que la profondeur de la cavité. Il convient ensuite de diminuer l'épaisseur du surplus de dépôt. Cela peut être fait par une gravure sèche sur l'ensemble de la plaque appelée « *etch back ».*

Il est possible également d'utiliser une opération de lithographie / gravure localisée sur la topographie avant CMP .

La figure 6b illustre cette étape de planarisation.

### Troisième étape :

On procède à la réalisation d'ouvertures supérieures **Oₛ** dédiées au contact supérieur et d'ouvertures inférieures **Oi** dédiées aux contacts inférieurs.

Ces ouvertures peuvent être réalisées par gravure sèche. Dans ce cas, la présence d'une couche d'arrêt à la gravure est optionnelle.

On peut aussi opérer par gravure séquentielles :
une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau **1** et sur le matériau **2.**

Cette (ces) gravure(s) peut (peuvent) être réalisée(s) directement via la résine utilisée pour la photolithographie ou préférentiellement à l'aide d'un masque dur composé par exemple de SiN.

La figure 6c illustre cette étape de réalisation d'ouvertures.

### Quatrième étape :

On procède au dépôt d'une métallisation compatible avec une filière silicium pour définir les contacts supérieurs et les contacts inférieurs permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal **3** compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C.

La température de recuit est préférentiellement ≤ 450 °C.

Selon l'option 1, on dépose le métal ou le composé intermétallique et on utilise le travail de sortie de ce dernier. Dans ce cas le recuit sert à guérir les défauts d'interface et cristalliser le métal ou le composé.

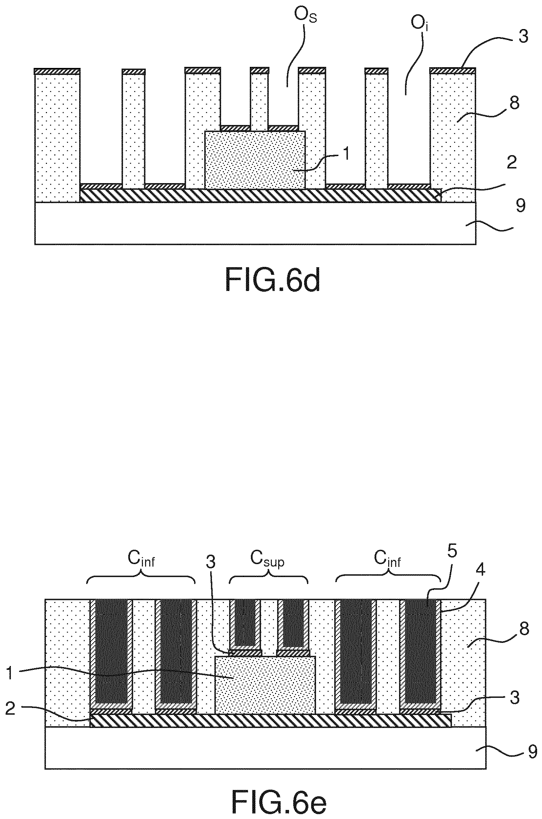

Cette étape est illustrée en figure 6d.

### Cinquième étape :

On procède au remplissage des ouvertures supérieures et des ouvertures inférieures et opération de CMP pour réaliser des plots de connexion. Le remplissage simultané des ouvertures supérieures et inférieures est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

Cette étape est illustrée en figure 6e.

Une variante du premier exemple de procédé comprenant la réalisation de contacts inférieurs suivie de celle de contact supérieur selon la première alternative, consiste à ajouter une étape de lithographie afin de supprimer la couche de métallisation **3** présente dans les plots du niveau bas (extérieurs). Cette dernière ajoute des interfaces et pourrait donc être néfaste d'un point de vue électrique.

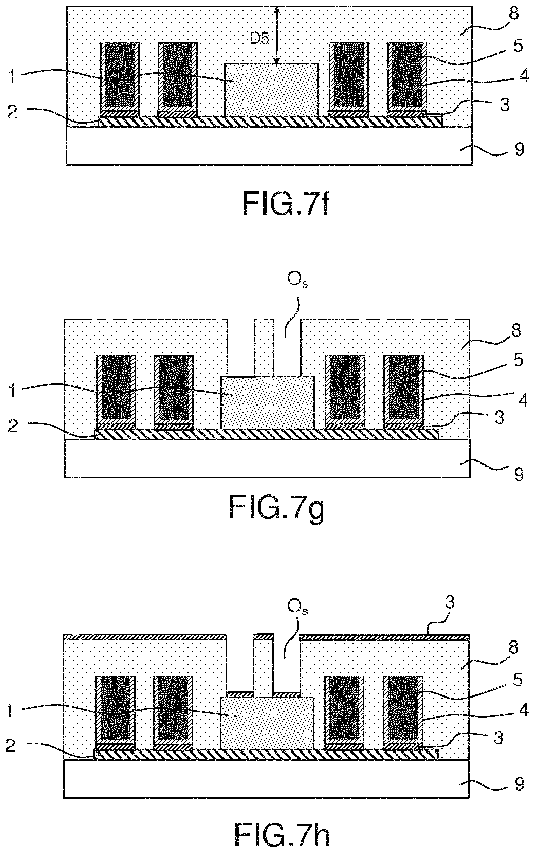

Cette variante est décrite ci-après et comprend des étapes communes à celles décrites en figures 4a à 4f et est illustrée grâce aux figures 7f à 7i, les mêmes lettres de références sont conservées pour une meilleure compréhension.

On réalise un ensemble dans lequel ont été préalablement réalisés des plots de contacts inférieurs, encapsulés dans du diélectrique **8** comme illustré en figure 7f.

Puis on réalise des ouvertures Oₛ au niveau du premier matériau **1,** dédiés au contact supérieur comme illustré en figure 7g. Ces ouvertures peuvent être réalisées par gravure sèche. Dans ce cas, la présence d'une couche d'arrêt à la gravure est optionnelle.

On peut aussi opérer par gravures séquentielles :
une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau **1.**

Cette (ces) gravure(s) peut (peuvent) être réalisée(s) directement via la résine utilisée pour la photolithographie ou préférentiellement à l'aide d'un masque dur composé par exemple de SiN.

On procède alors au dépôt d'une métallisation compatible avec une filière silicium pour définir les contacts supérieurs et les contacts inférieurs permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C.

La température de recuit est préférentiellement ≤ 450 °C.

Selon l'option 1, on dépose le métal ou le composé intermétallique et on utilise le travail de sortie de ce dernier. Dans ce cas le recuit sert à guérir les défauts d'interface et cristalliser le métal ou le composé.

Cette étape est illustrée en figure 7h.

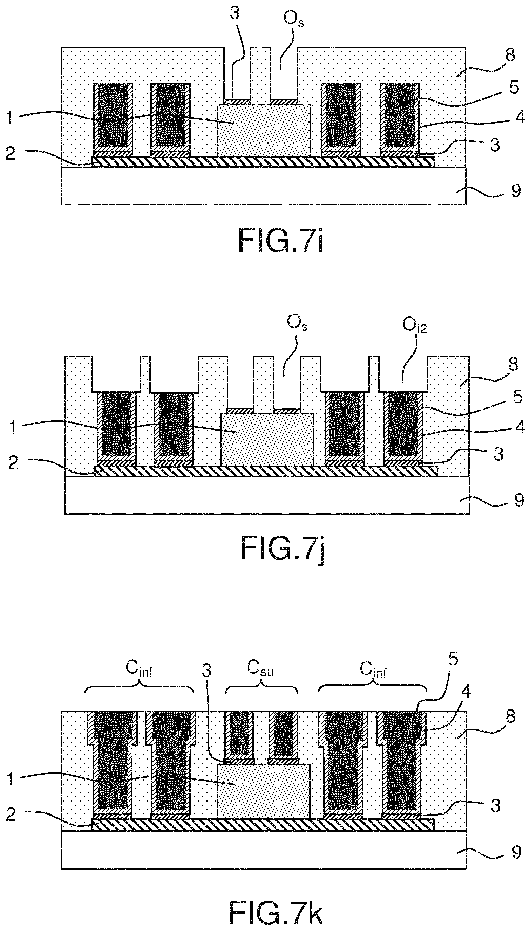

On procède alors à une opération de type CMP pour supprimer l'excellent de métal au sommet de l'empilement diélectrique, comme illustré en figure 7i, ne laissant présente la couche 3 qu'au niveau des ouvertures **Oₛ**.

On réalise alors des secondes ouvertures inférieures **Oᵢ₂** dédiés aux contacts inférieurs, comme illustré en figure 7j. Ces ouvertures peuvent être réalisées par gravure sèche. Dans ce cas, la présence d'une couche d'arrêt à la gravure est optionnelle.

On peut aussi opérer par gravures séquentielles :
Gravure stack diélectrique pour déboucher sur le matériau les plots extérieurs de contacts inférieurs :
- Gravure réalisée en une seule fois jusqu'au matériau de remplissage des plots du niveau bas: gravure sèche. Dans ce cas, la présence d'une couche d'arrêt à la gravure est optionnelle.
- Gravures séquentielles : une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau de remplissage des plots du niveau bas.

Cette (ces) gravure(s) peut (peuvent) être réalisée(s) directement via la résine utilisée pour la photolithographie ou préférentiellement à l'aide d'un masque dur composé par exemple de SiN.

On réalise alors les plots supérieurs et la partie supérieure des plots inférieurs, au dessus de la première partie des plots inférieure préalablement réalisée. Cette opération est réalisée par remplissage de l'ensemble des ouvertures **Oₛ** et **Oᵢ₂**.

Le remplissage simultané des ouvertures supérieures **Oₛ** et inférieures **Oᵢ₂** est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

Cette opération de remplissage est illustrée en figure 7k.

Une alternative aux ouvertures de plots décrites dans les trois exemples précédemment décrits consiste à intégrer les plots de contact en double damascène. Le double damascène est un procédé de gravure en deux étapes dans lequel le remplissage métallique puis la CMP permettant de retirer l'excès de métaux (Barrière d'une ou deux couches + remplissage) se font en successivement en une seule étape. Cela permet généralement de réaliser un via et une ligne qui débouche sur ce via. : connexion et routage.

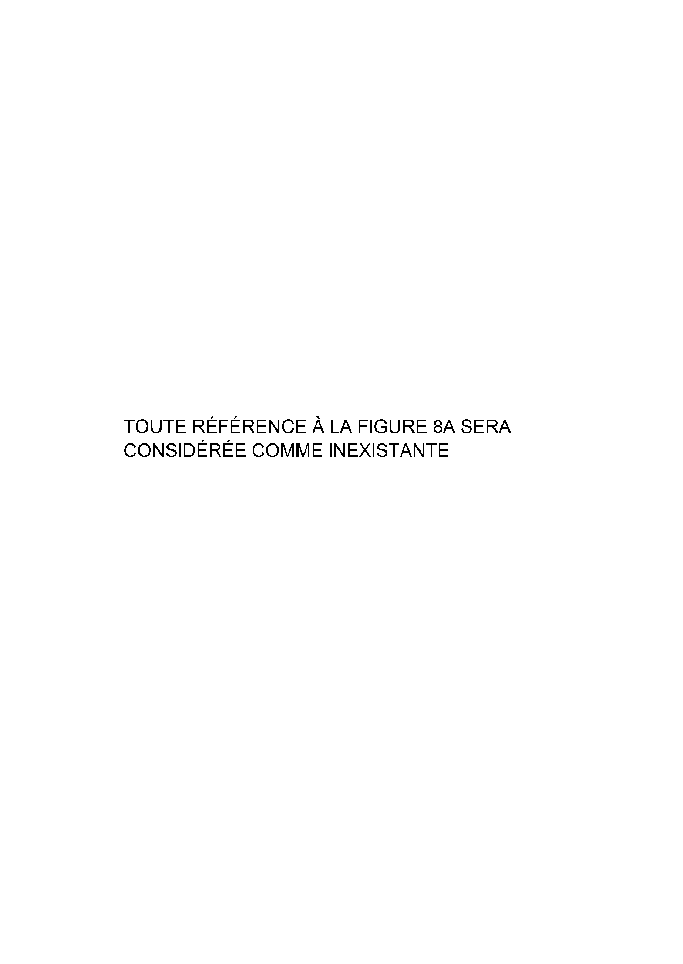

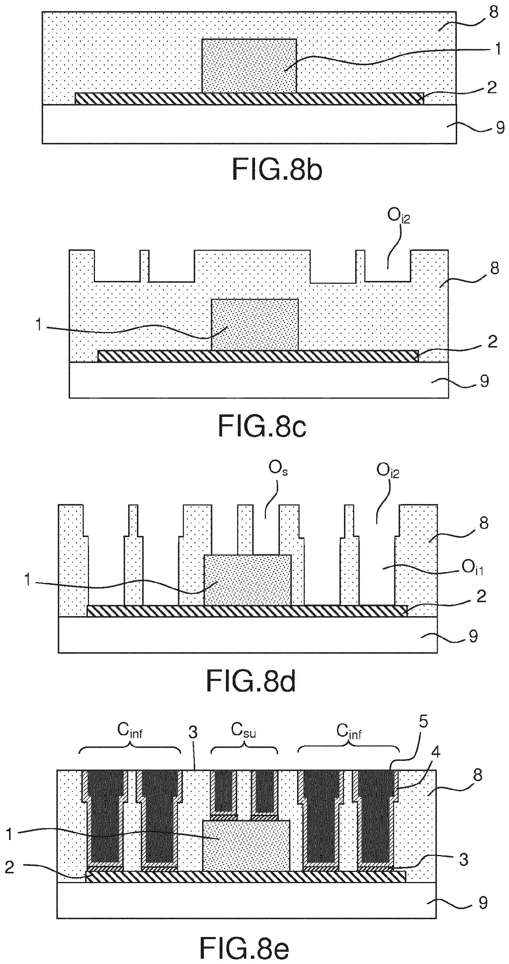

Cette alternative est représentée schématiquement suivant le mode de réalisation illustré grâce aux figures 8b à 8e. On réalise de manière similaire à celles précédemment décrites un ensemble encapsulé et aplani tel que celui illustré en figure 8b.

On réalise la partie haute des ouvertures inférieures dénommées secondes ouvertures inférieures **Oᵢ₂** par gravure partielle du diélectrique. On peut procéder par gravure sèche. Dans ce cas, la présence d'une couche d'arrêt à la gravure est optionnelle.

Cette (ces) gravure(s) peut (peuvent) être réalisée(s) directement via la résine utilisée pour la photolithographie ou à l'aide d'un masque dur composé par exemple de SiN.

Cette étape est illustrée en figure 8c.

On réalise une seconde opération de gravure du diélectrique permettant de réaliser des ouvertures supérieures **Oₛ** et la partie inférieure des ouvertures inférieures dénommées premières ouvertures inférieures **Oi₁**.

Ces ouvertures peuvent être réalisées par gravure sèche. Dans ce cas, la présence d'une couche d'arrêt à la gravure est optionnelle.

On peut aussi opérer par gravures séquentielles :
Gravure stack diélectrique pour déboucher sur le matériau les plots extérieurs de contacts inférieurs :
- Gravure réalisée en une seule fois jusqu'au matériau de remplissage des plots du niveau bas: gravure sèche. Dans ce cas, la présence d'une couche d'arrêt à la gravure est optionnelle.
- Gravures séquentielles : une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau de remplissage des plots du niveau bas.

Cette (ces) gravure(s) peut (peuvent) être réalisée(s) directement via la résine utilisée pour la photolithographie ou préférentiellement à l'aide d'un masque dur composé par exemple de SiN.

Cette étape est illustrée en figure 8d.

On réalise alors les plots des contacts inférieurs et supérieurs par remplissage. Le remplissage simultané des ouvertures supérieures **Oₛ** et inférieures **Oᵢ₂ et Oᵢ₂** est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

Cette opération de remplissage est illustrée en figure 8e.

Tous les modes de réalisations décrits dans les exemples précédents peuvent être complétés par un niveau d'intégration supplémentaire.

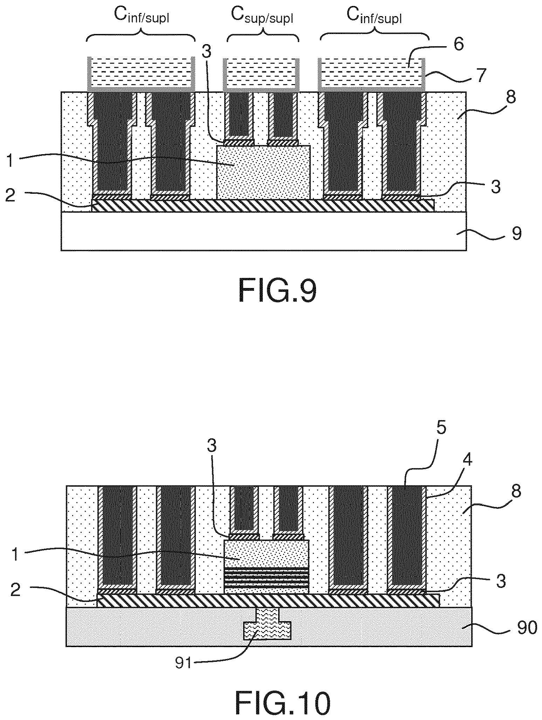

Une étape complémentaire peut ainsi être réalisée en procédant à un dépôt supplémentaire de diélectrique **8**, puis à la réalisation d'ouvertures supplémentaires supérieures et inférieures par gravure et au remplissage de ces ouvertures pour définir les contacts **C_{inf/supl}** et **C_{sup/supl}** comme illustré en figure 9.

Pour cela on procède, dans les ouvertures supplémentaires supérieures et inférieures, au dépôt d'une barrière **7** pouvant être en TiN, Ti/TiN, TaN, Ta/TaN, W et au remplissage par un métal **6** pouvant être du W, Cu ou Al, AlCu, AlSi .

### Exemple de composant laser réalisé selon le procédé de la première variante :

Le procédé selon la première variante permet avantageusement de réaliser un laser à base de matériaux III-V :
Un substrat **90** en SiO₂ comporte un guide **91** en silicium au dessus duquel sont réalisées :
- une base de second matériau III-V **2**, pouvant être en InP dopé n et une mesa **1** comprenant une structure multipuits quantiques pouvant être réalisés en InGaAsP avec différents dopages et une couche de InGaAs dopé p, la nature des matériaux III-V fixe la longueur d'onde d'émission ;
- le diélectrique **8** peut être en SiN, SiO₂, en polymère de type planarisant par exemple à base de BCB ;
- la métallisation **3** de fond de contact peut être par exemple en Ni,Ti, ou en leur alliages ( Ni₂P, Ni₃P, NiGe, TiP, TiGe, ....) ;
- la barrière de diffusion au F et/ou la couche d'accroche au W **4** peut être en TiN, Ti/TiN, TaN, Ta/TaN, W ;

Le métal de remplissage **5** peut être en Cu ou Al, AlCu, AlSi.

Cet exemple de laser est illustré en figure 10.

### Exemple de composant laser émettant verticalement de type VCSEL:

Il est rappelé que de manière générale, une diode laser à cavité verticale émettant par la surface, ou VCSEL ( *vertical-cavity surface-emitting laser*) est un type de diode laser à semi-conducteur émettant un rayon laser perpendiculairement à la surface, contrairement aux lasers conventionnels à semi-conducteur émettant par la tranche.

Cet exemple de laser, comporte principalement le même type de structure que celle décrite dans l'exemple précédent.

Néanmoins, afin de permettre une émission de rayonnement laser par le dessus de la structure, le contact supérieur est réalisé de manière circulaire.

Cet exemple de composant comprend un substrat **9** en silicium au dessus duquel sont réalisées une base de second matériau III-V **2**, pouvant être en InP dopé n et une mesa **1** comprenant une structure multipuits quantiques pouvant être à base de InGaAsP, AlGaAs, GaAs, InGaAsN et une couche de InGaAs dopé p , la nature des matériaux III-V fixe la longueur d'onde d'émission.

Le diélectrique **8** peut être en SiN, SiO₂, en polymère de type planarisant par exemple à base de BCB.

La métallisation **3** de fond de contact peut être par exemple en Ni, Ti, ou en leurs alliages ( Ni₂P, Ni₃P, NiGe, TiP, TiGe, ....).

La barrière de diffusion au F et/ou la couche d'accroche au W **4** peut être en TiN, Ti/TiN, TaN, Ta/TaN, W.

Le métal de remplissage **5** peut être en Cu ou Al, AlCu, AlSi.

Les métallisations **3** et les éléments **4** et **5** constituent les contacts **Cₛᵤₚ** et **C_{inf}.**

Grâce au contact supérieur circulaire **Cₛᵤₚ**, le faisceau laser peut être extrait depuis la surface supérieure du composant.

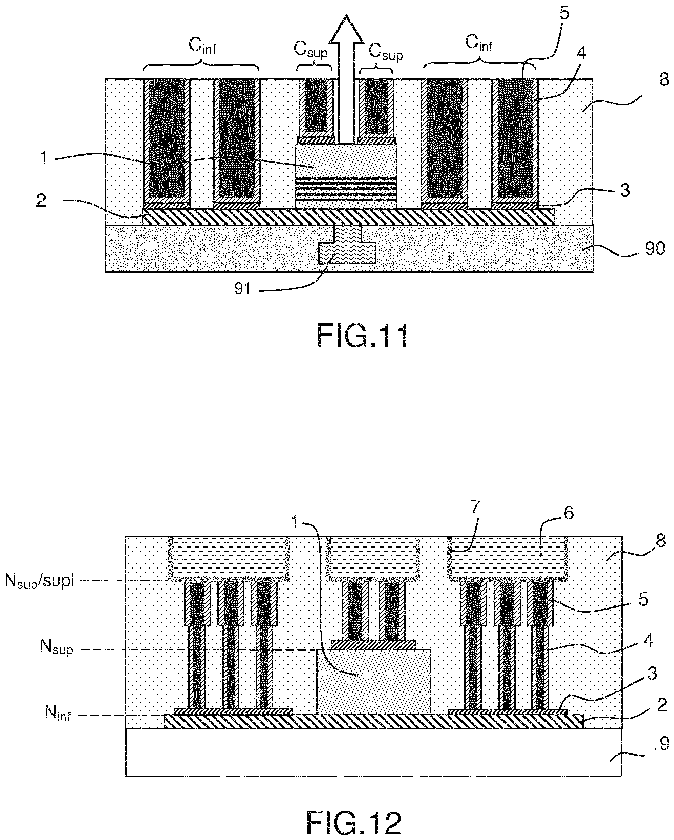

Cet exemple de laser est illustré en figure 11.

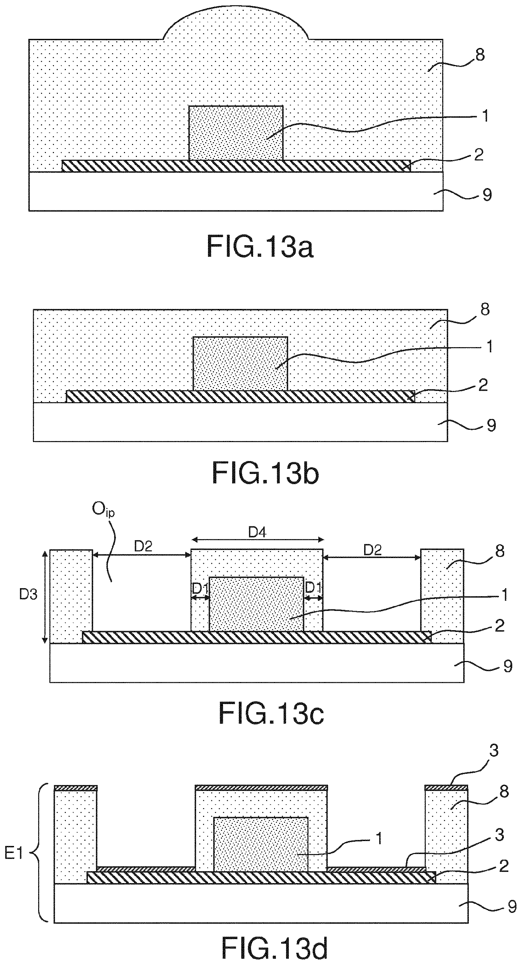

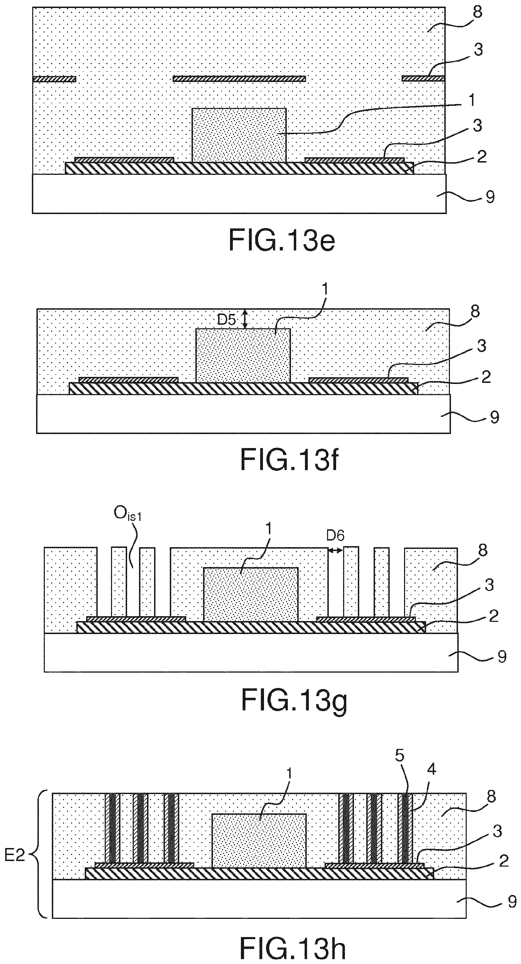

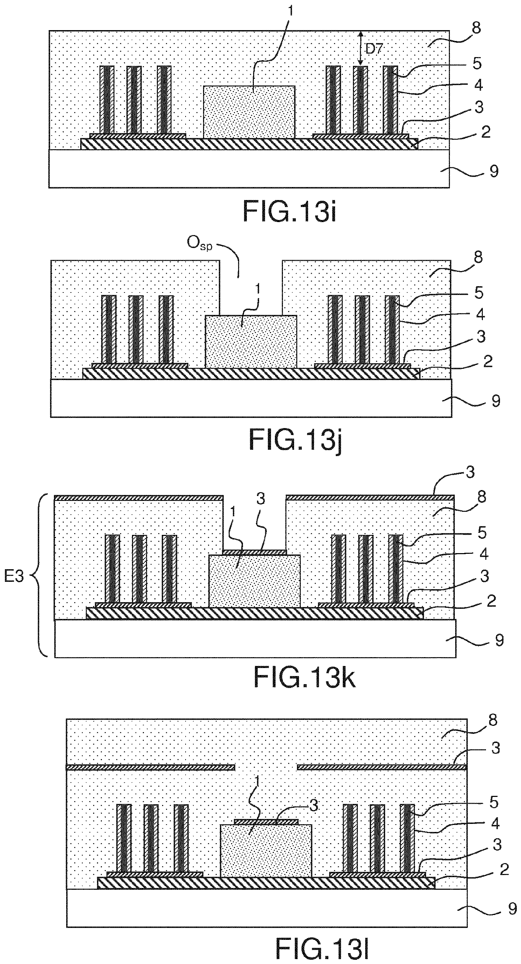

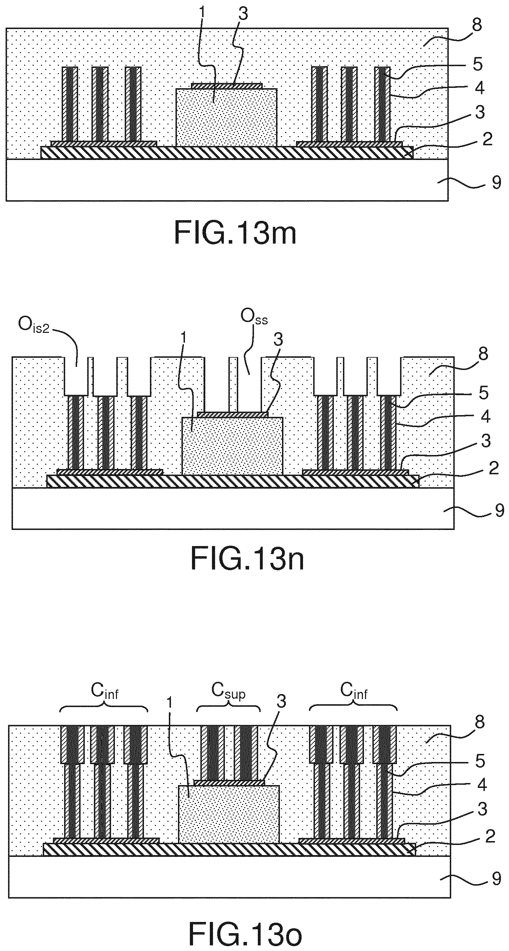

Les figures 3 à 12 précédemment décrites illustrent une première alternative qui n'est pas un mode de réalisation de l'invention. On s'attache à présent à décrire le procédé de l'invention qui est illustré par les figures 13 à 21.

### II) Procédé selon l'invention comportant la réalisation d'ouvertures primaires et d'ouvertures secondaires

Selon l'invention, on définit une métallisation de fond d'ouverture primaire et un plot de contact dans une ouverture secondaire. Le contact est ainsi constitué d'au moins la métallisation de fond d'ouverture et du plot de contact en contact avec ladite métallisation.

La figure 12 montre un exemple de composant obtenu selon un procédé de l'invention et mettant en évidence, sur un substrat **9,** les matériaux III-V **1** et **2,** des métallisations **3** servant de métallisations de fond de contact, sur lesquelles sont réalisés des plots de contact comprenant des barrières de diffusion **4,** les ouvertures secondaires sont remplies de métal de remplissage **5.** L'ensemble est encapsulé dans un diélectrique **8.** La figure 12 met en évidence les niveaux de contact : un niveau inférieur **N_{inf}**, un niveau supérieur **Nₛᵤₚ**. Selon cet exemple, il peut être prévu un niveau supplémentaire **N_{sup/supl}** sur lequel peuvent être réalisés des plots de contact remplis de barrière de diffusion **7** et de métal de remplissage **6.**

Le premier matériau III-V peut être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As.

Le second matériau III-V peut également être constitué de matériau III-V tel que InP, In₁₋ₓGaₓAs (avec 0 ≤ x ≤ 1), GaAs, InAs, du GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}A. Il peut être identique au premier matériau ou différent de ce dernier.

Le substrat peut être un substrat en silicium pouvant par exemple présenter une épaisseur de l'ordre de quelques centaines de millimètres (par exemple 200 mm ).

### Premier exemple de procédé selon l'invention comprenant la réalisation de contacts inférieurs suivie de celle de contact supérieur selon l'invention :

### Première étape :

On procède à l'encapsulation de la structure préalablement réalisée et comportant une mesa en un premier matériau III-V 1 à la surface d'une base en un matériau III-V **2** sur un substrat **9.**

Le (les) diélectriques **8** utilisés peuvent être : SiN, SiO₂, Al₂O₃, polymère de type planarisant par exemple à base de benzocyclobutane (BCB), ou de type: SOG « Spin-On-Glass » : dépôt de diélectrique amorphe par centrifugation.

### Le dépôt peut être monocouche ou multicouches.

Les diélectriques sont déposés par PVD (dépôt physique en phase vapeur), CVD (dépôt chimique en phase vapeur) et/ou ALD (dépôt de couches minces atomique. Typiquement la température de dépôt peut être ≤ 550 °C, préférentiellement ≤ 450 °C.

Le stress des couches réalisées peut avantageusement être ≤ 200 MPa, préférentiellement ≤ 100 MPa.

La figure 13a illustre cette étape d'encapsulation.

### Deuxième étape :

On procède à la planarisation du diélectrique par une opération de CMP pour *"chemical mechanical planarization"* ou *"chemical mechanical polishing"* (planarisation ou polissage mécano chimique) ou de retrait partiel par gravure sèche « *etch back* » dans le cas d'un polymère planarisant

Il existe certains polymères qui ont la propriété d'être auto-nivellant. C'est-à-dire qu'ils vont remplir en premier lieu les parties inférieures avant les parties supérieures. Mais pour être assuré de remplir les cavités entièrement le dépôt est plus épais que la profondeur de la cavité. Il convient ensuite de diminuer l'épaisseur du surplus de dépôt. Cela peut être fait par une gravure sèche sur l'ensemble de la plaque appelée « *etch back ».*

Il est possible également d'utiliser une opération de lithographie / gravure localisée sur la topographie avant CMP .

La figure 13b illustre cette étape de planarisation.

### Troisième étape :

On procède à la réalisation d'ouvertures inférieures primaires **Oᵢₚ** dédiées au contact inférieur.

Typiquement les dimensions D1, D2, D3 et D4 peuvent être les suivantes :
La dimension D1 (largeur de diélectrique de part et d'autre de la mesa en matériau III-V **1**) est au minimum de 200 nm et préférentiellement comprise entre 2 et 3 µm.

La dimension D2 (largeur des ouvertures inférieures primaires) peut être comprise entre 20 et 50 µm.

La dimension D3 (épaisseur de diélectrique) est comprise entre 0,5 µm et 5 µm, préférentiellement entre 5 et 3 µm.

La dimension D4 (largeur centrale entre les deux ouvertures inférieures primaires) peut être comprise entre 0,5 µm et 10 µm, préférentiellement comprise entre 1 et 5 µm

Pour cela on réalise la gravure localisée du diélectrique (dans le cas de plusieurs couches) pour déboucher sur le matériau III-V **2**. On peut réaliser la gravure en une seule fois jusqu'au matériau III-V **2** par une opération de gravure sèche. Dans ce cas, la présence d'une couche d'arrêt à la gravure est optionnelle.

On peut procéder également à des opérations de gravures séquentielles : une première gravure sèche utilisée pour graver une partie du de l'empilement diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau III-V **2.**

Cette (ces) gravure(s) peut (peuvent) être réalisée(s) directement via la résine utilisée pour la photolithographie ou préférentiellement à l'aide d'un masque dur composé par exemple de SiN.

Cette étape de réalisation d'ouvertures est illustrée en figure 13c.

### Quatrième étape :

On procède au dépôt d'une métallisation compatible avec une filière silicium pour définir le contact inférieur permettant d'éviter l'emploi de métaux nobles, métaux non utilisés par la filière silicium.

La métallisation compatible avec une filière silicium peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C

La température de recuit est préférentiellement ≤ 450 °C

Selon l'option 1, on dépose le métal ou le composé intermétallique et on utilise le travail de sortie de ce dernier. Dans ce cas le recuit sert à guérir les défauts d'interface et cristalliser le métal ou le composé.

Selon l'option 2, on dépose le métal, on le fait réagir pour former le composé intermétallique ayant le travail de sortie visé. Dans ce cas le recuit sert à la réaction à l'état solide.

Un retrait sélectif du métal n'ayant pas réagi peut-être réalisé après traitement thermique.

On obtient alors un ensemble **E1** illustré en figure 13d.

### Cinquième étape :

On procède à une étape d'encapsulation de l'ensemble **E1** par du diélectrique **8.** Le (les) diélectrique(s) utilisés peuvent être: SiN, SiO₂, Al₂O₃, polymère de type planarisant (par exemple BCB, SOG). Le dépôt peut être monocouche ou multicouches. Ils sont déposés par PVD, CVD et/ou ALD ;

La température de dépôt est ≤ 450 °C, préférentiellement ≤ 300 °C.

Cette étape est illustrée en figure 13e.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape.

### Sixième étape :

On procède à la planarisation du diélectrique par une opération de CMP ou une opération de type « *etch back* » dans le cas d'un polymère planarisant.

La planarisation CMP ou « *etch back* » peuvent être réalisées :
- si le retrait sélectif n'a pas été effectué à la quatrième étape, jusqu'au retrait du métal ;
- si le retrait sélectif n'a pas été effectué à la quatrième étape, et si l'opération de type CMP ou *« etch back »* du métal est impossible, avec arrêt sur le métal. L'étape de retrait sélectif du métal peut alors être réalisée pour obtenir une structure comme illustré en figure 13f ;
- si le retrait sélectif a été effectué à la quatrième étape, jusqu'à obtenir une structure comme illustré en figure 13f.

Typiquement, la hauteur D5 représentée (épaisseur de diélectrique au dessus du matériau III-V **1**) peut être comprise entre 200 nm et 1 µm.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape ou à l'issue de la cinquième étape.

### Septième étape :

On procède à une opération d'ouvertures inférieures secondaires supérieures **Oᵢₛ₁** destinées aux plots de connexion. Pour cela on procède à une gravure du stack diélectrique pour déboucher sur la métallisation **3** au niveau inférieur.

La gravure est réalisée en une seule fois jusqu'à la métallisation : gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC, préférentiellement SiN), puis une gravure sèche ou humide est utilisée pour graver la couche d'arrêt et les éventuelles couches sous-jacentes et déboucher sur la métallisation **3**.

Cette (ces) gravure(s) peut (peuvent) être réalisée(s) directement via la résine utilisée pour la photolithographie ou à l'aide d'un masque dur composé par exemple de SiN. Typiquement la dimension D6 (largeur des ouvertures inférieures secondaires) représentée de diélectrique peut être comprise entre 0,5 µm et 5 µm et de préférence comprise entre 1 µm et 3 µm. Cette étape est illustrée en figure 13g.

### Huitième étape :

On procède au remplissage des ouvertures inférieures secondaires et opération de CMP pour réaliser des plots de connexion. Le remplissage des ouvertures inférieures secondaires est fait en deux temps :
- on procède au dépôt d'une barrière de diffusion / d'une couche d'accroche ou de nucléation **4.** Elle peut être composée de TiN, Ti/TiN, TaN, Ta/TaN ou de W déposés par CVD, PVD ou ALD ;
- on procède au dépôt d'un métal de remplissage **5** (W, Cu, AlCu, AlSi) déposé par CVD, ECD ou PVD.

Une opération de CMP est finalement réalisée pour décontacter les plots. Le métal étant présent au sommet des cavités entre deux plots, un court-circuit est donc inévitable. L'opération de CMP permet de retirer uniquement le métal hors des plots et donc de décontacter.

On constitue un nouvel ensemble **E2.** L'ensemble de ces étapes est illustré en figure 13h.

### Neuvième étape :

On procède à une opération d'encapsulation par un diélectrique **8.** Le (les) diélectriques utilisés peuvent être : SiN, SiO₂, Al₂O₃, un polymère de type planarisant (par exemple BCB, SOG). Le dépôt peut être monocouche ou multicouches. Les diélectriques sont déposés par PVD, CVD et/ou ALD. La température de dépôt ≤ 450 °C, préférentiellement ≤ 300 °C. Typiquement la hauteur D7 représentée de diélectrique peut être comprise entre 200 nm et 1 µm et de préférence comprise entre 200 nm et 500 nm. Cette étape est illustrée en figure 13i.

### Dixième étape :

On procède à la réalisation d'ouverture supérieure primaire **Oₛₚ** pour réaliser un contact supérieur.

On procède à la gravure du stack diélectrique pour déboucher sur le matériau III-V **1.** La gravure peut être réalisée en une seule fois jusqu'au matériau III-V **1** par gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC préférentiellement SiN) puis une gravure sèche ou humide est utilisée pour graver la couche d'arrêt et les éventuelles couches sous-jacentes et déboucher sur le matériau III-V **1.**

Cette (ces) gravure(s) peut (peuvent) être réalisée(s) directement via la résine utilisée pour la photolithographie ou préférentiellement à l'aide d'un masque dur composé par exemple de SiN.

Cette étape est illustré en figure 13j.

### Onzième étape :

On procède au dépôt de la métallisation **3** compatible avec une filière silicium destinée au contact supérieur. La métallisation compatible avec une filière silicium peut être réalisée de deux façons :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

### La température recuit est préférentiellement ≤ 450 °C

Un retrait sélectif du métal n'ayant pas réagi peut-être réalisé après traitement thermique. On obtient un troisième ensemble **E3.**

Cette étape est illustrée en figure 13k.

### Douzième étape :

On procède à l'encapsulation du troisième ensemble **E3.** Le (les) diélectrique(s) utilisés peuvent être: SiN, SiO₂, Al₂O₃, polymère de type planarisant (par exemple BCB), SOG. Le dépôt peut être monocouche ou multicouches. Ils sont déposés par PVD, CVD et/ou ALD. La température de dépôt ≤ 450 °C, préférentiellement ≤ 300 °C.

Cette étape est illustrée en figure 13I.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la onzième étape.

### Treizième étape :

On procède à une opération de planarisation.

La planarisation ou l'etch back peuvent être réalisés :
- si le retrait sélectif n'a pas été effectué à la onzième étape, jusqu'au retrait du métal ;
- si le retrait sélectif n'a pas été effectué à la onzième étape, et si la l'opération de CMP ou de *« etch back »* du métal est impossible, avec arrêt sur le métal. L'étape de retrait sélectif du métal peut alors être réalisée pour obtenir une structure comme représenté en figure 4m ;
- si le retrait sélectif a été effectué à la onzième étape, jusqu'à obtenir la structure illustrée en figure 13m.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la onzième étape ou à l'issue de la douzième étape.

### Quatorzième étape :

On procède à la réalisation d'ouverture supérieure secondaire **Oₛₛ** et à la réalisation d'ouvertures supplémentaires supérieures **Oᵢₛ₂** au dessus au moins des plots de contact d'un contact inférieur.

On procède à la gravure du stack diélectrique pour déboucher sur la métallisation du niveau de contact supérieur et sur les plots de contact du contact inférieur.

La gravure est réalisée en une seule fois jusqu'à la métallisation **3** et jusqu'aux plots du niveau inférieur, par gravure sèche. Dans ce cas, la présence d'une couche d'arrêt à la gravure est optionnelle.

On peut procéder à des opérations de gravures séquentielles : une première gravure sèche est utilisée pour graver une partie du stack diélectrique avec arrêt sur une couche d'arrêt (SiN, Al₂O₃, SiO₂, BCB, SOC, préférentiellement SiN) sur la métallisation de fond de contact supérieur et sur les plots du contact inférieur ;

On peut utiliser une gravure sèche ou humide pour graver la couche d'arrêt et les éventuelles couches sous-jacentes et déboucher sur la métallisation **3**.

Cette (ces) gravure(s) peut (peuvent) être réalisée(s) directement via la résine utilisée pour la photolithographie ou à l'aide d'un masque dur composé par exemple de SiN.

Cette étape est illustrée en figure 13n.

### Quinzième étape :

On procède au remplissage des ouvertures définies à l'étape précédente.

Le remplissage des ouvertures est réalisé en deux temps :
- on procède au dépôt d'un dépôt d'une barrière de diffusion / d'une couche d'accroche ou de nucléation. Elle peut être composée de TiN, Ti/TiN, TaN, Ta/TaN ou de W déposés par CVD, PVD ou ALD ;
- on procède au dépôt d'un métal de remplissage (W, Cu, AlCu, AlSi..) déposé par CVD, ECD ou PVD.

Une opération de CMP est finalement réalisée pour décontacter les plots.

Cette étape est illustrée en figure 13o et conduit à la réalisation des contacts supérieur **Cₛᵤₚ** et inférieur **C_{inf}**.

Une alternative au premier exemple de procédé peut comprendre une réalisation séquentielle des ouvertures primaires couplée à une réalisation simultanée des ouvertures secondaires.

### Second exemple de procédé selon l'invention comprenant la réalisation de contacts supérieur suivie de celle de contacts inférieurs selon l'invention :

### Première étape :

On procède à l'encapsulation de la structure préalablement réalisée et comportant une mesa en un premier matériau III-V **1** à la surface d'une base en un matériau III-V **2** sur un substrat **9.**

Le (les) diélectriques **8** utilisés peuvent être : SiN, SiO₂, Al₂O₃, polymère de type planarisant (par exemple BCB, SOG).

Le dépôt peut être monocouche ou multicouches.

Les diélectriques sont déposés par PVD, CVD et/ou ALD. Typiquement la température de dépôt peut être ≤ 450 °C, préférentiellement ≤ 300 °C.

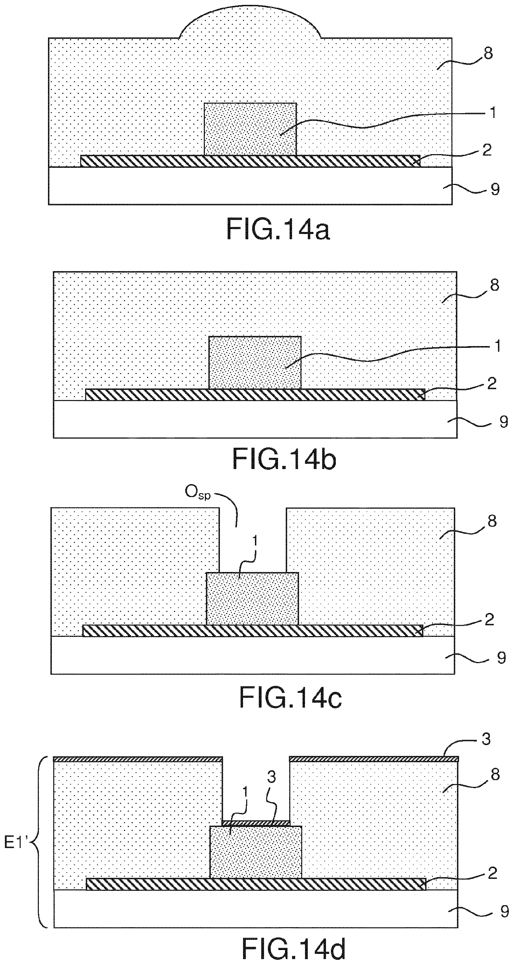

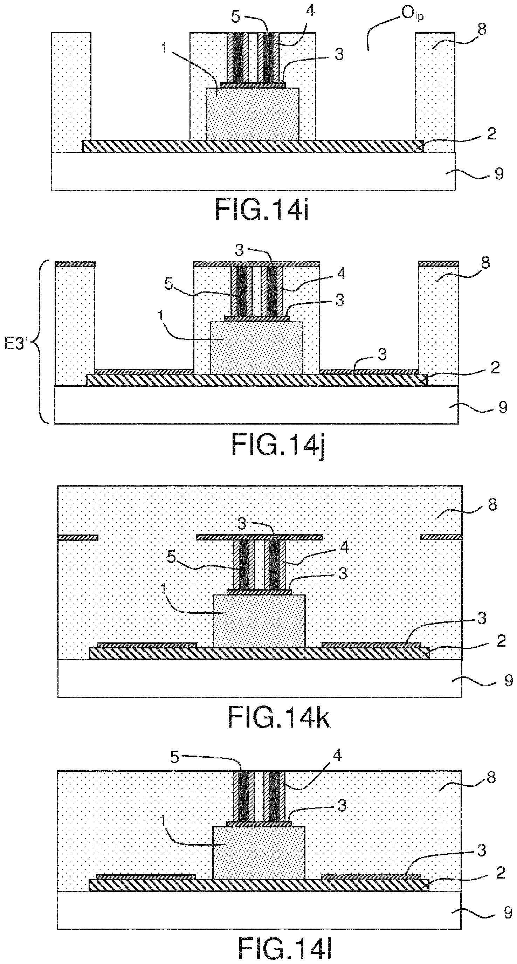

Le stress des couches réalisées peut être ≤ 200 MPa, préférentiellement ≤ 100 MPa. La figure 14a illustre cette étape d'encapsulation.

### Deuxième étape :

On procède à la planarisation du diélectrique par une opération de type CMP ou de type « *etch back* » dans le cas d'un polymère planarisant. Il est possible également d'utiliser une opération de lithographie / gravure localisée sur la topographie avant CMP. La figure 14b illustre cette étape de planarisation.

### Troisième étape :

On procède à la réalisation d'ouverture supérieure primaire **Oₛₚ** dédiée au contact supérieur.

Pour cela on réalise la gravure localisée du diélectrique (dans le cas de plusieurs couches) pour déboucher sur le matériau III-V **1.** On peut réaliser la gravure en une seule fois jusqu'au matériau III-V **1** par une opération de gravure sèche. Dans ce cas, la présence d'une couche d'arrêt à la gravure est optionnelle.

On peut procéder également à des opérations de gravures séquentielles : une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau III-V **1.**

Cette (ces) gravure(s) peut (peuvent) être réalisée(s) directement via la résine utilisée pour la photolithographie ou préférentiellement à l'aide d'un masque dur composé par exemple de SiN.

Cette étape de réalisation d'ouvertures est illustrée en figure 14c.

### Quatrième étape :

On procède au dépôt d'une métallisation **3** compatible avec une filière silicium sur le matériau III-V **1.**

La métallisation peut être réalisée selon deux options :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

### La température de recuit est préférentiellement ≤ 450 °C.

Un retrait sélectif du métal n'ayant pas réagi peut-être réalisé après traitement thermique.

On obtient alors un ensemble **E1'** illustré en figure 14d.

### Cinquième étape :

On procède à une étape d'encapsulation de l'ensemble **E1'** par du diélectrique **8.** Le (les) diélectrique(s) utilisés peuvent être: SiN, SiO₂, Al₂O₃, polymère de type planarisant (par exemple BCB, SOG). Le dépôt peut être monocouche ou multicouches. Ils sont déposés par PVD, CVD et/ou ALD ;

Température de dépôt ≤ 450 °C, préférentiellement ≤ 300 °C.

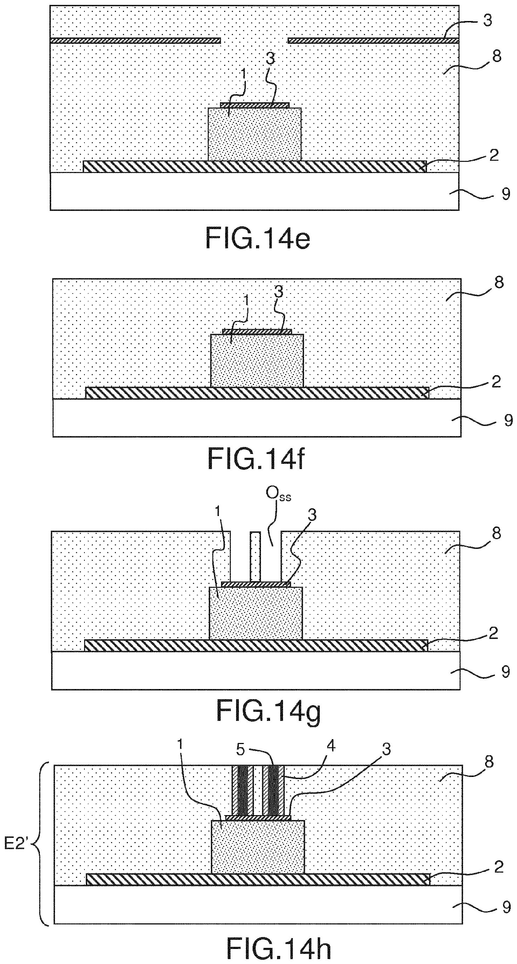

Cette étape est illustrée en figure 14e.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape.

### Sixième étape :

On procède à la planarisation du diélectrique par une opération de type CMP ou de type « *etch back* » dans le cas d'un polymère planarisant. Ces opérations peuvent être réalisées :
- si le retrait sélectif n'a pas été effectué à la quatrième étape, jusqu'au retrait du métal ;
- si le retrait sélectif n'a pas été effectué à la quatrième étape, et si la l'opération de type CMP ou de type « *etch back »* du métal est impossible, avec arrêt sur le métal. L'étape de retrait sélectif du métal peut alors être réalisée pour obtenir une structure comme illustré en figure 14f ;
- si le retrait sélectif a été effectué à la quatrième étape, jusqu'à obtenir une structure comme illustré en figure 14f.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape ou à l'issue de la cinquième étape.

### Septième étape :

On procède à une opération d'ouvertures supérieures secondaires **Oₛₛ** destinées aux plots de connexion. Pour cela on procède à une gravure du stack diélectrique pour déboucher sur la métallisation **3** au niveau supérieur.

La gravure est réalisée en une seule fois jusqu'à la métallisation pouvant être par gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC, préférentiellement SiN), puis une gravure sèche ou humide est utilisée pour graver la couche d'arrêt et les éventuelles couches sous-jacentes et déboucher sur la métallisation **3.**

Cette (ces) gravure(s) peut (peuvent) être réalisée(s) directement via la résine utilisée pour la photolithographie ou à l'aide d'un masque dur composé par exemple de SiN.

Cette étape est illustrée en figure 14g.

### Huitième étape :

On procède au remplissage des ouvertures **Oₛₛ** et à une opération de CMP pour réaliser des plots de connexion.

Le remplissage des ouvertures **Oₛₛ** est fait en deux temps :
- on procède au dépôt d'une barrière de diffusion / d'une couche d'accroche ou de nucléation. Elle peut être composée de TiN, Ti/TiN, TaN, Ta/TaN ou de W déposés par CVD, PVD ou ALD ;
- on procède au dépôt d'un métal de remplissage (W, Cu, AlCu, AlSi,... ) déposé par CVD, ECD ou PVD.

Une CMP est finalement réalisée pour décontacter les plots. On constitue un nouvel ensemble **E2'.** L'ensemble de ces étapes est illustré en figure 14h.

### Neuvième étape :

On procède à la réalisation d'ouvertures inférieures primaires **Oᵢₚ** pour réaliser des contacts inférieurs.

On procède à la gravure du stack diélectrique pour déboucher sur le matériau III-V **2.** La gravure peut être réalisée en une seule fois jusqu'au matériau III-V **2** par gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC préférentiellement SiN) puis une gravure sèche ou humide est utilisée pour graver la couche d'arrêt et les éventuelles couches sous-jacentes et déboucher sur le matériau III-V **2.**

Cette (ces) gravure(s) peut (peuvent) être réalisée(s) directement via la résine utilisée pour la photolithographie ou préférentiellement à l'aide d'un masque dur composé par exemple de SiN.

Cette étape est illustré en figure 14i.

### Dixième étape :

On procède au dépôt de la métallisation **3** compatible avec une filière silicium destinée aux contacts inférieurs. La métallisation compatible CMOS peut être réalisée de deux façons :
On procède au dépôt de la métallisation **3** compatible avec une filière silicium destinée au contact supérieur. La métallisation peut être réalisée de deux façons :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

Les températures de dépôt sont préférentiellement ≤ 450 °C
La température recuit est préférentiellement ≤ 450 °C

Un retrait sélectif du métal n'ayant pas réagi peut-être réalisé après traitement thermique. On obtient un troisième ensemble **E3'.**

Cette étape est illustrée en figure 14j.

### Onzième étape :

On procède à une étape d'encapsulation de l'ensemble **E3'** par du diélectrique **8.** Le (les) diélectrique(s) utilisés peuvent être: SiN, SiO₂, Al₂O₃, polymère de type planarisant (par exemple BCB), SOG. Le dépôt peut être monocouche ou multicouches. Ils sont déposés par PVD, CVD et/ou ALD ;

Température de dépôt ≤ 450 °C, préférentiellement ≤ 300 °C.

Cette étape est illustrée en figure 14k.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la dixième étape.

### Douzième étape :

On procède à une opération de planarisation du diélectrique par une opération de type CMP ou de type « *etch back* » dans le cas d'un polymère planarisant.

Cette étape est illustrée en figure 14I.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la dixième étape ou à l'issue de la douzième étape.

### Treizième étape :

On procède à une opération d'ouvertures inférieures secondaires **Oᵢₛ** destinés aux plots de connexion. Pour cela on procède à une gravure du stack diélectrique pour déboucher sur la métallisation **3** au niveau inférieur.

La gravure est réalisée en une seule fois jusqu'à la métallisation par gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC, préférentiellement SiN), puis une gravure sèche ou humide est utilisée pour graver la couche d'arrêt et les éventuelles couches sous-jacentes et déboucher sur la métallisation **3.**

Cette (ces) gravure(s) peut (peuvent) être réalisée(s) directement via la résine utilisée pour la photolithographie ou à l'aide d'un masque dur composé par exemple de SiN. Typiquement la hauteur D6 représentée de diélectrique peut être comprise entre 0,5 µm et 5 µm et de préférence comprise entre 1 µm et 3 µm.

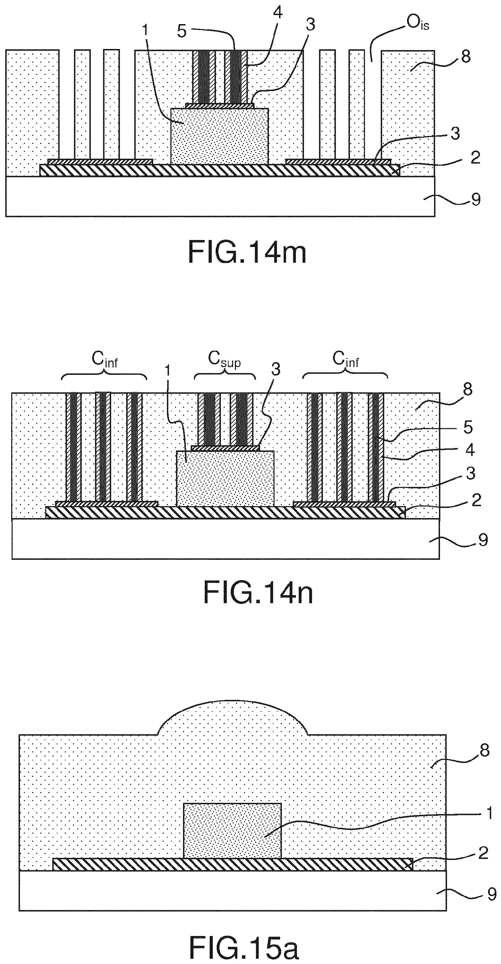

Cette étape est illustrée en figure 14m.

### Quatorzième étape :

On procède au remplissage des ouvertures définies à l'étape précédente.

Le remplissage des ouvertures est réalisé en deux temps :
- on procède au dépôt d'un dépôt d'une barrière de diffusion / d'une couche d'accroche ou de nucléation. Elle peut être composée de TiN, Ti/TiN, TaN, Ta/TaN ou de W déposés par CVD, PVD ou ALD ;
- on procède au dépôt d'un métal de remplissage (W, Cu) déposé par CVD, ECD ou PVD.

Une opération de CMP est finalement réalisée pour décontacter les plots.

Cette étape est illustrée en figure 14n et conduit à la réalisation des contacts supérieur **Cₛᵤₚ** et inférieur **C_{inf}**.

Une alternative au second exemple de procédé peut comprendre une réalisation séquentielle des ouvertures primaires couplée à une réalisation simultanée des ouvertures secondaires.

### Troisième exemple de procédé selon l'invention comprenant la réalisation simultanée de contact supérieur et de contact inférieur selon l'invention:

### Première étape :

On procède à l'encapsulation de la structure préalablement réalisée et comportant une mesa en un premier matériau III-V **1** à la surface d'une base en un matériau III-V **2** sur un substrat **9.**

Le (les) diélectriques **8** utilisés peuvent être : SiN, SiO₂, Al₂O₃, polymère de type planarisant (par exemple BCB, SOG).

Le dépôt peut être monocouche ou multicouches.

Les diélectriques sont déposés par PVD, CVD et/ou ALD. Typiquement la température de dépôt peut être ≤ 450 °C, préférentiellement ≤ 300 °C.

Le stress des couches réalisées peut être ≤ 200 MPa, préférentiellement ≤ 100 MPa. La figure 15a illustre cette étape d'encapsulation.

### Deuxième étape :

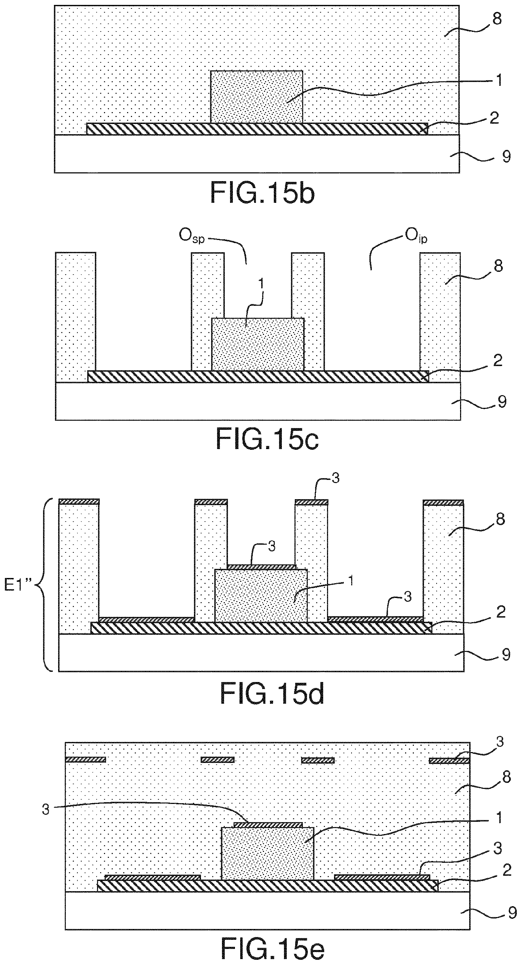

On procède à la planarisation du diélectrique par une opération de type CMP ou de type « *etch back* » dans le cas d'un polymère planarisant. Il est possible également d'utiliser une opération de lithographie / gravure localisée sur la topographie avant CMP. La figure 15b illustre cette étape de planarisation.

### Troisième étape :

On procède à la réalisation d'ouvertures inférieures primaires **Oᵢₚ** dédiées au contact inférieur et à une ouverture supérieure primaire **Oₛₚ** dédiée au contact supérieur.

Pour cela on réalise la gravure localisée du diélectrique (dans le cas de plusieurs couches) pour déboucher sur le matériau III-V **2** et pour déboucher sur le matériau III-V **1.**

On peut réaliser la gravure en une seule fois jusqu'au matériau III-V **2** et jusqu'au matériau **1** par une opération de gravure sèche. Dans ce cas, la présence d'une couche d'arrêt à la gravure est optionnelle.

On peut procéder également à des opérations de gravures séquentielles : une première gravure sèche utilisée pour graver une partie du stack diélectrique avec arrêt sur une couche d'arrêt (SiN, Al₂O₃, SiO₂, BCB, SOC préférentiellement SiN) puis utilisation d'une gravure sèche ou humide pour graver la couche d'arrêt et les éventuelles couches sous-jacentes et déboucher sur le matériau III-V **2** et sur le matériau III-V **1.**

Cette (ces) gravure(s) peut (peuvent) être réalisée(s) directement via la résine utilisée pour la photolithographie ou préférentiellement à l'aide d'un masque dur composé par exemple de SiN.

Cette étape de réalisation d'ouvertures est illustrée en figure 15c.

### Quatrième étape :

On procède au dépôt d'une métallisation **3** compatible avec une filière silicium sur le matériau III-V **1** et sur le matériau III-V **2.**

On procède au dépôt de la métallisation **3** compatible avec une filière silicium destinée au contact supérieur. La métallisation peut être réalisée de deux façons :
- option 1 :
   (a) on réalise le dépôt d'un métal **3** compatible avec une filière silicium tel que Ni₂P, Ni₃P, NiGe, TiP, TiGe...;
      On peut procéder à la stabilisation des phases par un traitement thermique optionnel réalisé après le dépôt métallique ;
   (b) on réalise le dépôt d'un métal 3 compatible avec une filière silicium tel que Ni, Ti et alliage comme NiPt, NiTi, NiCo... ;
- option 2 : on réalise le dépôt d'un métal compatible avec une filière silicium (Ni, Ti et leurs alliages) ; puis on procède à un traitement thermique ayant pour but de réaliser une réaction à l'état solide entre le métal et le matériau III-V menant à la formation d'un ou plusieurs composé(s) intermétallique(s).

La température de recuit est préférentiellement ≤ 450 °C

Un retrait sélectif du métal n'ayant pas réagi peut-être réalisé après traitement thermique.

On obtient alors un ensemble **E1"** illustré en figure 15d.

### Cinquième étape :

On procède à une étape d'encapsulation de l'ensemble **E1"** par du diélectrique **8.** Le (les) diélectrique(s) utilisés peuvent être: SiN, SiO₂, Al₂O₃, polymère de type planarisant (par exemple BCB, SOG). Le dépôt peut être monocouche ou multicouches. Ils sont déposés par PVD, CVD et/ou ALD ;

La température de dépôt est ≤ 450 °C, préférentiellement ≤ 300 °C.

Cette étape est illustrée en figure 15e.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape.

### Sixième étape :

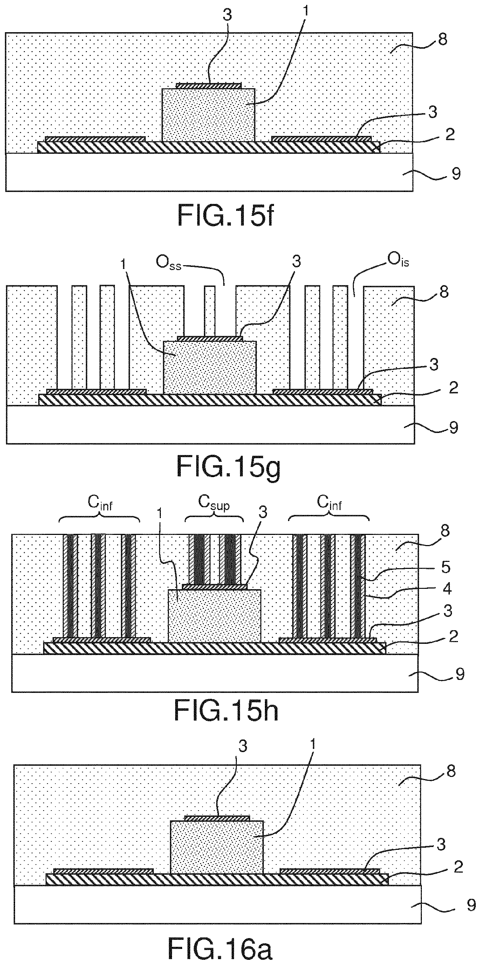

On procède à la planarisation du diélectrique par une opération de type CMP ou de type « *etch back* » dans le cas d'un polymère planarisant. Ces opérations peuvent être réalisées :
- si le retrait sélectif n'a pas été effectué à la quatrième étape, jusqu'au retrait du métal ;
- si le retrait sélectif n'a pas été effectué à la quatrième étape, et si l'opération de type CMP ou de type « *etch back »* du métal est impossible, avec arrêt sur le métal. L'étape de retrait sélectif du métal peut alors être réalisée pour obtenir une structure comme illustré en figure 15f ;
- si le retrait sélectif a été effectué à la quatrième étape, jusqu'à obtenir une structure comme illustré en figure 15f.

Les opérations de stabilisation des phases ou de traitement thermique pour former un ou plusieurs composé(s) intermétallique(s) peuvent être réalisées à l'issue de cette étape, si elles n'ont pas été réalisées à l'issue de la quatrième étape ou à l'issue de la cinquième étape.

### Septième étape :

On procède à une opération d'ouvertures supérieures secondaires **Oₛₛ** et à des ouvertures inférieures secondaires **Oᵢₛ** destinées aux plots de connexion. Pour cela on procède à une gravure du stack diélectrique pour déboucher sur la métallisation **3** au niveau supérieur et au niveau inférieur.

La gravure est réalisée en une seule fois jusqu'à la métallisation par gravure sèche. Dans ce cas, la présence d'une couche d'arrêt à la gravure est optionnelle.

On peut procéder à des gravures séquentielles : une première gravure sèche est utilisée pour graver une partie du stack diélectrique avec arrêt sur une couche d'arrêt (SiN, Al₂O₃, SiO₂, BCB, SOC, préférentiellement SiN), puis une gravure sèche ou humide est utilisée pour graver la couche d'arrêt et les éventuelles couches sous-jacentes et déboucher sur la métallisation **3.**

Cette (ces) gravure(s) peut (peuvent) être réalisée(s) directement via la résine utilisée pour la photolithographie ou à l'aide d'un masque dur composé par exemple de SiN.

Cette étape est illustrée en figure 15g.

### Huitième étape :

On procède au remplissage des ouvertures définies à l'étape précédente.

Le remplissage des ouvertures est réalisé en deux temps :
- on procède au dépôt d'un dépôt d'une barrière de diffusion / d'une couche d'accroche ou de nucléation. Elle peut être composée de TiN, Ti/TiN, TaN, Ta/TaN ou de W déposés par CVD, PVD ou ALD ;
- on procède au dépôt d'un métal de remplissage (W, Cu) déposé par CVD, ECD ou PVD.

Une opération de CMP est finalement réalisée pour décontacter les plots.

Cette étape est illustrée en figure 15h et conduit à la réalisation des contacts supérieur **Cₛᵤₚ** et inférieur **C_{inf.}**

Une alternative aux trois exemples de procédés décrits précédemment consiste à réaliser des plots de contact présentant plusieurs tronçons pour le contact inférieur.

### Quatrième exemple de procédé selon l'invention :

### Première étape :

On réalise selon des sous-étapes identiques à celles précédemment décrites un ensemble comprenant :
- un substrat **9 ;**
- un matériau III-V **1** ;
- un matériau III-V **2** ;
- des métallisations **3** ;

L'ensemble est encapsulé dans un diélectrique **8** et est illustré en figure 16a.

### Deuxième étape :

On procède à la réalisation d'ouvertures inférieures secondaires **Oᵢₛ₁** par gravure partielle de l'ensemble préconstitué, soit par la gravure partielle du diélectrique **8.** On peut procéder par gravure sèche. Dans ce cas, la présence d'une couche d'arrêt à la gravure est optionnelle.

Cette (ces) gravure(s) peut (peuvent) être réalisée(s) directement via une résine utilisée pour la photolithographie ou à l'aide d'un masque dur composé par exemple de SiN.

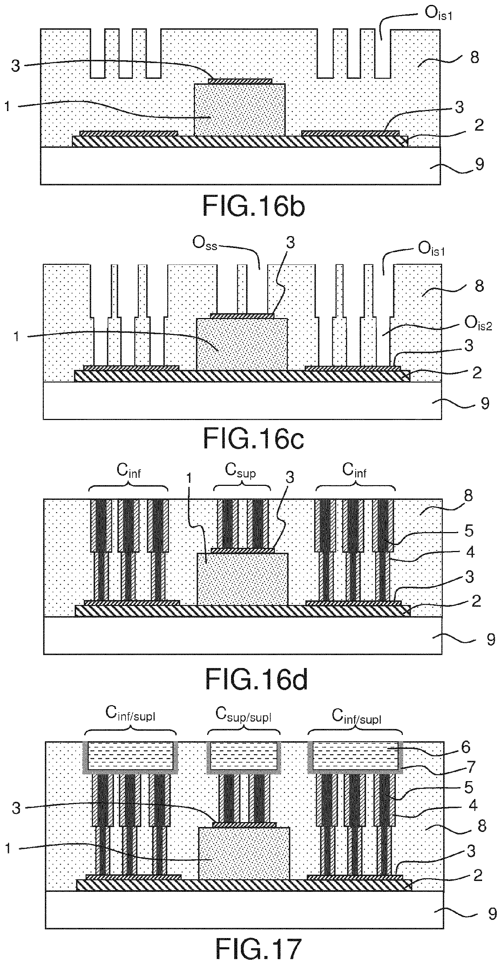

Cette étape est illustrée en figure 16b.

### Troisième étape :

On procède dans un second temps à une seconde opération de gravure pour prolonger les ouvertures inférieures secondaires, en procédant à la réalisation des ouvertures **Oᵢₛ₂** dans le prolongement des ouvertures précédemment réalisées **Oᵢₛ₁**, et à réaliser des ouvertures supérieures secondaires **Oₛₛ** de manière à déboucher sur les métallisations **3.**

L'opération de gravure peut être réalisée en une seule fois jusqu'à la métallisation et ce par gravure sèche. Dans ce cas, la présence d'une couche d'arrêt à la gravure est optionnelle.

Préférentiellement, on peut réaliser des opérations de gravures séquentielles : une première gravure sèche utilisée pour graver une partie du stack diélectrique avec arrêt sur une couche d'arrêt (SiN, Al₂O₃, SiO₂, BCB, SOC, préférentiellement SiN) puis utilisation d'une gravure sèche ou humide pour graver la couche d'arrêt et les éventuelles couches sous-jacentes et déboucher sur les métallisations.

Cette (ces) gravure(s) peut (peuvent) être réalisée(s) directement via la résine utilisée pour la photolithographie ou à l'aide d'un masque dur composé par exemple de SiN.

Cette étape est illustrée en figure 16c.

### Quatrième étape :

On procède au remplissage des ouvertures définies à l'étape précédente.

Le remplissage des ouvertures est réalisé en deux temps :
- on procède au dépôt d'un dépôt d'une barrière de diffusion / d'une couche d'accroche ou de nucléation. Elle peut être composée de TiN, Ti/TiN, TaN, Ta/TaN ou de W déposés par CVD, PVD ou ALD ;
- on procède au dépôt d'un métal de remplissage (W, Cu, AlCu, AlSi) déposé par CVD, ECD ou PVD.

Une opération de CMP est finalement réalisée pour décontacter les plots.

Cette étape est illustrée en figure 16d et conduit à la réalisation des contacts supérieur **Cₛᵤₚ** et inférieur **C_{inf.}**

De manière générale, il est possible de réaliser un niveau supplémentaire de contact à la surface des contacts planaires préalablement élaborés et notamment décrits dans les précédents exemples de procédé selon l'invention.

Une étape complémentaire peut ainsi être réalisée en procédant à un dépôt supplémentaire de diélectrique **8,** puis à la réalisation d'ouvertures supplémentaires supérieures et inférieures par gravure et au remplissage de ces ouvertures pour définir les contacts **C_{inf/supl}** et **C_{sup/supl}** comme illustré en figure 17.

Pour cela on procède, dans les ouvertures supplémentaires supérieures et inférieures, au dépôt d'une barrière **7** pouvant être en TiN, Ti/TiN, TaN, Ta/TaN, W et au remplissage par un métal **6** pouvant être du W, Cu ou Al, AlCu, AlSi .

Il est à noter que le niveau supplémentaire de contact peut également être réalisé par la gravure d'un empilement métallique préalablement réalisé via une résine ou un masque dur.

### Exemple de composant laser réalisé selon le procédé de l'invention :

Le procédé de la présente invention permet avantageusement de réaliser un laser à base de matériaux III-V :
Un substrat **90** en SiO₂ comporte un guide **91** en silicium au dessus duquel sont réalisées :
- une base de second matériau III-V **2,** pouvant être en InP dopé n et une mesa **1** comprenant une structure multipuits quantiques pouvant être réalisés en InGaAsP avec différents dopages et une couche de InGaAs dopé p, la nature des matériaux III-V fixe la longueur d'onde d'émission ;
- le diélectrique **8** peut être en SiN, SiO₂, en polymère de type planarisant par exemple à base de BCB ;
- la métallisation **3** de fond de contact peut être par exemple en Ni,Ti, ou en leur alliages ( Ni₂P, Ni₃P, NiGe, TiP, TiGe, ....) ;
- la barrière de diffusion au F et/ou la couche d'accroche au W **4** peut être en TiN, Ti/TiN, TaN, Ta/TaN, W ;

Le métal de remplissage **5** peut être en Cu ou Al, AlCu, AlSi.

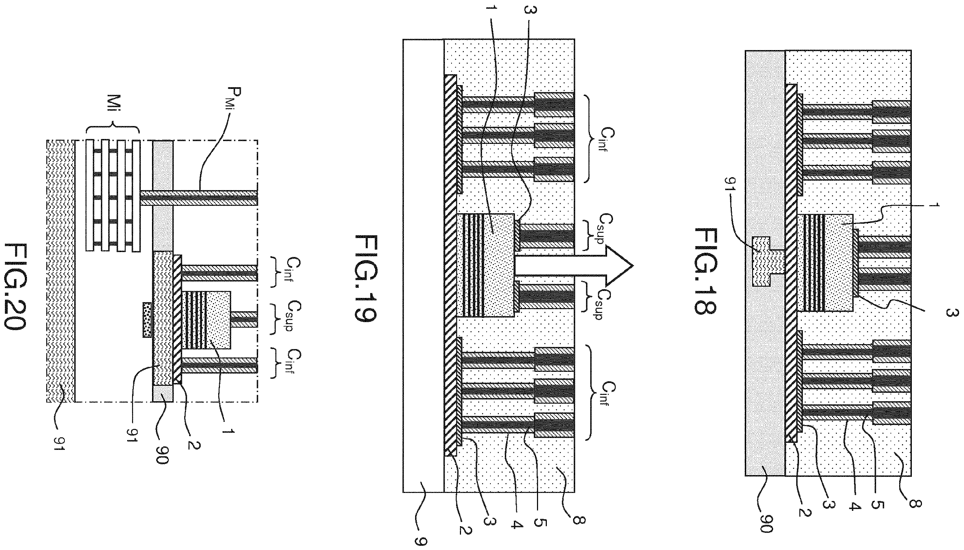

Cet exemple de laser est illustré en figure 18.

### Exemple de composant laser émettant verticalement de type VCSEL:

Il est rappelé que de manière générale, une diode laser à cavité verticale émettant par la surface, ou VCSEL ( *vertical-cavity surface-emitting laser*) est un type de diode laser à semi-conducteur émettant un rayon laser perpendiculairement à la surface, contrairement aux lasers conventionnels à semi-conducteur émettant par la tranche.

Cet exemple de laser, comporte principalement le même type de structure que celle décrite dans l'exemple précédent.

Néanmoins, afin de permettre une émission de rayonnement laser par le dessus de la structure, le contact supérieur est réalisé de manière circulaire.

Cet exemple de composant comprend un substrat **9** en silicium au dessus duquel sont réalisées une base de second matériau III-V **2,** pouvant être en InP dopé n et une mesa **1** comprenant une structure multipuits quantiques pouvant être à base de InGaAsP, AlGaAs, GaAs, InGaAsN et une couche de InGaAs dopé p , la nature des matériaux III-V fixe la longueur d'onde d'émission.

Le diélectrique **8** peut être en SiN, SiO₂, en polymère de type planarisant par exemple à base de BCB.

La métallisation **3** de fond de contact peut être par exemple en Ni,

Ti, ou en leurs alliages ( Ni₂P, Ni₃P, NiGe, TiP, TiGe, ....).

La barrière de diffusion au F et/ou la couche d'accroche au W **4** peut être en TiN, Ti/TiN, TaN, Ta/TaN, W.

Le métal de remplissage **5** peut être en Cu ou Al, AlCu, AlSi.

Les métallisations **3** et les éléments **4** et **5** constituent les contacts **Cₛᵤₚ** et **C_{inf}**.

Grâce au contact supérieur circulaire **Cₛᵤₚ**, le faisceau laser peut être extrait depuis la surface supérieure du composant.

Cet exemple de laser est illustré en figure 19 .

L'intégration de contacts planaires ouvre typiquement pour les composants laser décrits précédemment la voie à une intégration 3D, par le biais d'un collage hybride ou direct (par exemple photonique / électronique) ou du report de puces par le biais de bumps.

Dans le cadre d'une co-intégration III-V/Si, la réalisation d'un back-end planarisé permet également d'envisager la reprise de contact sur les dispositifs des niveaux inférieurs (back-end front side ou intermétallique par exemple).

Un exemple est donné en figure 20 dans le cadre d'une intégration Photonique avec la réalisation de l'ensemble des contacts décrits précédemment **Cₛᵤₚ** et **C_{inf},** sur le composant III-V (laser) et sur le back-end de la partie silicium . Les contacts supplémentaires sont assurés par les plots **P_{Mi}** qui connectent des niveaux métalliques **Mi,** intégrés dans du diélectrique **8.** Typiquement le substrat **91** peut être du silicium, le diélectrique **90** pouvant être du SiO₂.

### Exemple de composant utilisé dans des applications de type cellule solaire dans lequel on empile une série de matériaux III-V différents, permettant de diversifier les longueurs d'onde d'émission

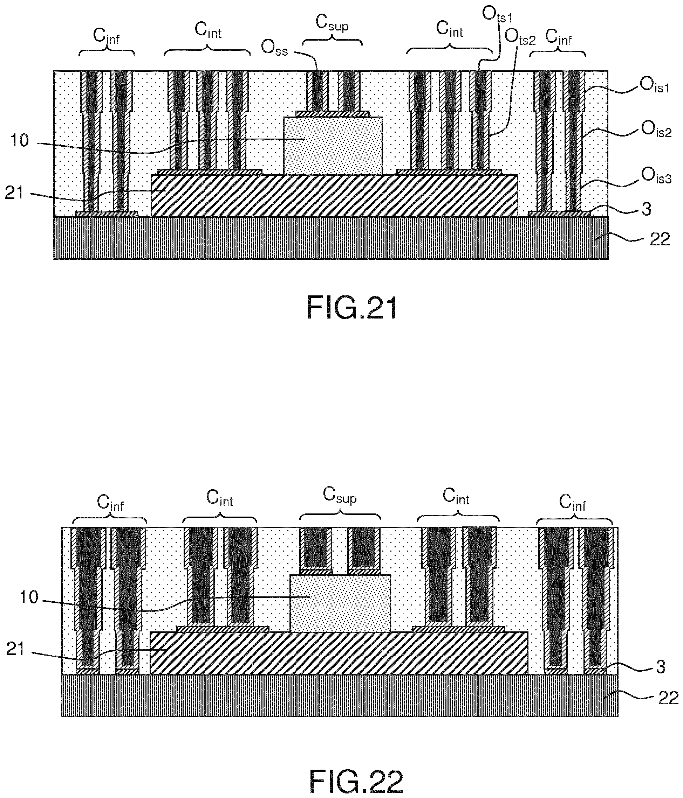

Cet exemple de composant comprend un substrat **9** en silicium au dessus duquel sont empilés comme illustré en figure 21 :
- un matériau III-V **22** situé à un niveau dit inférieur ;
- un matériau III-V **21** situé à un niveau dit intermédiaire ;
- un matériau III-V **10** situé à un niveau dit supérieur.

Le composant comprend :
- des contacts **C_{inf}** de matériau **22 ;**
- des contacts **Cᵢₙₜ** de matériau **21 ;**
- des contacts **Cₛᵤₚ** de matériaux **10.**

Les contacts **C_{inf}** sont réalisés grâce au remplissage de l'empilement d'ouvertures réalisées successivement : **Oᵢₛ₁**, **Oᵢₛ₂** et **Oᵢₛ₃**.

Les contacts **Cᵢₙₜ** sont réalisés grâce au remplissage de l'empilement d'ouvertures réalisées successivement : **Oₜₛ₁**, **Oₜₛ₂**.

Les contacts **Cₛᵤₚ** sont réalisés grâce au remplissage d'ouverture : **Oₛₛ.**

Typiquement les matériaux III-V utilisés peuvent être notamment : InGaAsN, BInGaAs, InGaN, GaInP, GaInAsP, GaAs.

Une variante de l'exemple illustré en figure 21, est illustré en figure 22 et montre une solution mixte des deux alternatives décrites précédemment : des ouvertures d'un seul type sur deux des matériaux III-V **10** et **22** et des ouvertures primaires et des ouvertures secondaires sur l'autre matériau III-V **21.** Cette figure 22 ne décrit pas un mode de réalisation appartenant à l'invention.

La réalisation des contacts se fait sur deux matériaux III-V de différente nature (InP et InGaAs) dont le type de dopage est différent. Quel que soit le contact réalisé, par réaction à l'état solide ou simple par le dépôt de l'électrode, la résistivité d'interface Rc est différente.

Dans la cas où la résistivité d'interface Rc est faible et la longueur de transfert plus petite que l'ouverture secondaire on peut ne réaliser qu'une seule ouverture pour contacter le matériau III-V.

Dans le cas contraire, il faut réaliser une double ouverture. On peut avoir les deux conditions sur l'une et l'autre des couches III-V et donc dans certains cas, il est possible de privilégier une solution mixant les deux alternatives.

La solution consistant à réaliser un seul type d'ouverture demeure une solution privilégiée lorsqu'elle est adaptée car elle minimise le nombre d'étapes et dont une seul ensemble d'opérations (phot /litho / gravure).

Le Demandeur explicite ci-après les conditions permettant d'établir le choix entre les deux alternatives d'élaboration du contact :
- un seul type d'ouverture pour réaliser la métallisation en fond de contact et le remplissage ;
- deux types d'ouverture : une ouverture primaire très grande pour la métallisation puis des ouvertures secondaires pour réaliser le contact et le remplissage.

Le critère de choix est la longueur de transfert. Cette longueur est la longueur qui va être nécessaire et donc parcourue par les lignes du champ électrique pour passer du contact métallique dans le semi-conducteur III/V.

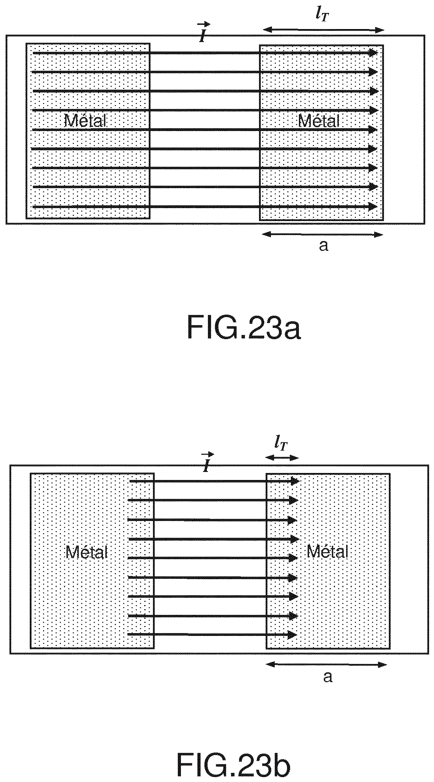

Les figures 23a et 23b, mettent en évidence deux contacts référencés Métal et des lignes de champ électrique qui passent d'une électrode à l'autre en passant par le substrat semi-conducteur.

La longueur de transfert se définit par la distance (et aussi l'aire) d'injection des porteurs entre les bords du plots métalliques, Lt qui est utilisée pour injecter le courant dans le semi-conducteur : ${L}_{T} = \sqrt{\frac{{ρ}_{C}}{{R}_{SK}}}$

Cette distance dépend essentiellement de deux paramètres : la résistivité de contact ρ_{C} et la résistance de « feuille » couramment dénommée « Sheet Résistance » du substrat sous-jacent au contact.

Avec ces éléments on comprend que :
- si la longueur Lₜ est plus faible que la dimension des ouvertures secondaires (Lt < a), on peut envisager une intégration avec uniquement ce type d'ouverture : métallisation en fond de contact et remplissage ;
- si la longueur Lₜ est plus grande que la dimension des ouvertures secondaires (Lt > a), dans ce cas, il convient de procéder avec deux types d'ouvertures, la métallisation d'une plus grande surface qui dans le cadre de la présente demande des brevets est plus grande que la dimension Lt, puis des ouvertures secondaires plus petites pour le remplissage.

La longueur de transfert se mesure de manière expérimentale en élaborant des structures simples (TLM) qui donnent directement accès à cette grandeur. Il suffit de réaliser des plots sur le semi-conducteur dopé et réaliser une mesure de courant entre chacun de ces plots.

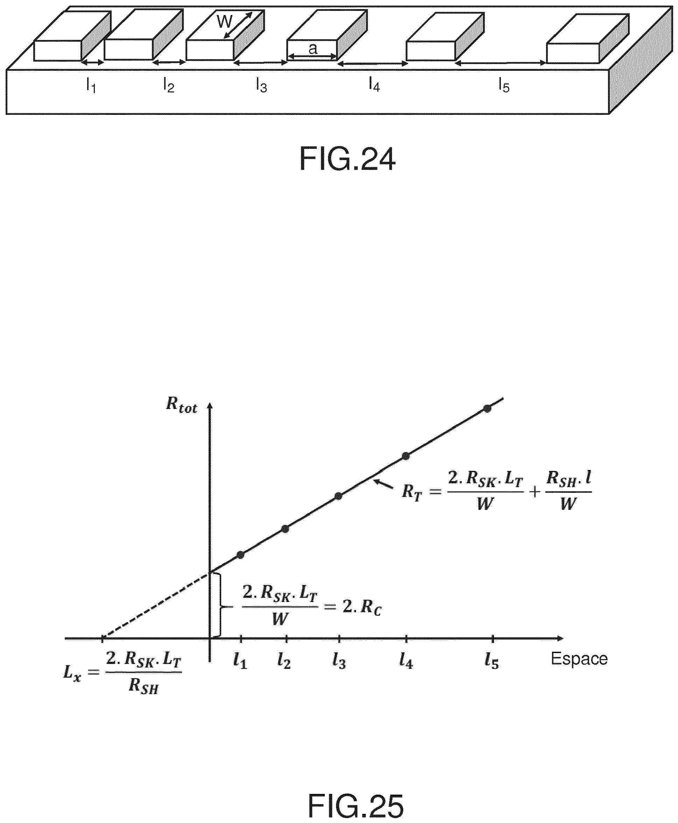

La figure 24 schématise ce type de structure TLM avec des contacts identiques de dimensions surfaciques W.a, séparés par des distances croissantes li, W étant la largeur du contact définie comme étant perpendiculaire aux lignes du champ électrique.

En traçant la résistance en fonction de la distance, une droite est obtenue si les contacts sont faiblement résistifs et on obtient à l'intersection de cette droite avec l'axe des ordonnées : 2 x la résistance de contact et à l'intersection avec l'axe des abscisses : 2 x la longueur de transfert, comme représenté en figure 25 avec comme hypothèse R ₛₕ = R ₛₖ (résistance sous le plot), la résistance totale correspondant aux résistances de contact, aux « Sheet Résistance » et à la résistance du substrat.

Bien qu'approximative dans le cadre des contacts obtenus par réaction à l'état solide, cette méthode est suffisamment précise pour distinguer les deux cas d'intérêt et faire le choix d'intégration optimum.

Il est à noter que si Lt > a, on peut tout de même choisir l'intégration la plus simple et la moins coûteuse en faisant un compromis sur la résistance totale du dispositif dès lors que cette dernière reste acceptable pour le fonctionnement dudit dispositif (performance souhaitée et échauffement acceptable pour la durée de vie du dispositif concerné).

## Revendications

1. Procédé de réalisation d'un composant comprenant une structure en matériau(x) III-V à la surface d'un substrat, ladite structure comprenant au moins un niveau supérieur de contact (**Nₛᵤₚ**) défini à la surface d'un premier matériau III-V **(1)** qui s'étend latéralement au dessus dudit substrat et un niveau inférieur de contact (**N_{inf}**) défini à la surface d'un second matériau III-V **(2)** qui s'étend latéralement au dessus dudit substrat, comportant :
- l'encapsulation par au moins un diélectrique **(8)** de ladite structure
- la réalisation dans ledit diélectrique **(8)** d'au moins une ouverture supérieure primaire (**Oₛₚ**) à la surface dudit premier matériau III-V **(1)** et d'au moins une ouverture inférieure primaire (**Oᵢₚ**) à la surface dudit second matériau III-V **(2)** de manière à définir des zones de fond de contact sur ledit premier matériau III-V et sur ledit second matériau III-V ;
- la réalisation de métallisations de fond de contact **(3)** dans ladite au moins ouverture supérieure primaire et dans ladite au moins ouverture inférieure primaire, de manière à former une structure intermédiaire;
- l'encapsulation de la structure intermédiaire par au moins un diélectrique **(8)** de ladite au moins ouverture supérieure primaire (**Oₛₚ**) et de ladite au moins ouverture inférieure primaire (**Oᵢₚ**) ;
- la réalisation d'au moins une ouverture supérieure secondaire (**Oₛₛ**) dans le diélectrique situé dans ladite au moins ouverture supérieure primaire (**Oₛₚ**), et la réalisation d'au moins une ouverture inférieure secondaire (**Oᵢₛ**) dans le diélectrique situé dans ladite ouverture inférieure primaire (**Oᵢₚ**),
- le remplissage de ladite au moins ouverture supérieure secondaire (**Oₛₛ**) et de ladite au moins ouverture inférieure secondaire (**Oᵢₛ**) par au moins une matière métallique **(5)** de manière à réaliser au moins un plot de contact supérieur sur une surface de métallisation de fond de contact inférieure à la surface de la métallisation de fond de contact déposée dans ladite au moins ouverture supérieure primaire et au moins un plot de contact inférieur sur une surface de métallisation de fond de contact inférieure à la surface de la métallisation de fond de contact déposée dans ladite au moins ouverture inférieure primaire ;- les métallisations de fond de contact et les plots de contact définissant au moins un contact supérieur dudit premier matériau III-V en contact avec ledit niveau supérieur de contact (**Nₛᵤₚ**) et au moins un contact inférieur dudit second matériau III-V en contact avec ledit niveau inférieur de contact (**N_{inf}**) ;
- au moins ledit contact supérieur et au moins ledit contact inférieur sont partiellement intégrés dans du diélectrique et présentent une surface supérieure non recouverte par le diélectrique et définie dans un même plan ;
- les métallisations de fond de contact (3) étant de nature différente de celle de la matière métallique (5) ;
- ladite structure présentant une base inférieure en second matériau III-V **(2)** et une mesa en premier matériau III-V **(1)** située au dessus de ladite base.

2. Procédé de réalisation selon la revendication 1, **caractérisé en ce qu'**il comprend la réalisation successive d'au moins une ouverture supérieure primaire puis d'au moins une ouverture inférieure primaire.

3. Procédé de réalisation selon la revendication 1, **caractérisé en ce qu'**il comprend la réalisation simultanée d'au moins une ouverture supérieure secondaire et d'au moins une ouverture inférieure secondaire.

4. Procédé de réalisation selon la revendication 1 à 3, **caractérisé en ce qu'**il comporte :
- l'encapsulation par du diélectrique d'un ensemble comprenant le matériau III-V **(1)** recouvert d'une métallisation **(3)** et le matériau III-V **(2)** recouvert d'une métallisation **(3)** ;
- la réalisation d'au moins une ouverture inférieure secondaire (**Oᵢₛ₁**) en regard du second matériau III-V **(2) ;**
- la réalisation d'au moins une ouverture supérieure secondaire (**Oₛₛ**) au dessus dudit premier matériau III-V **(1)** et la réalisation d'au moins une ouverture inférieure secondaire supplémentaire (**Oᵢₛ₂**) au dessus d'au moins ladite ouverture inférieure secondaire (**Oᵢₛ₁**) ;
- le remplissage d'au moins ladite ouverture supérieure secondaire (**Oₛₛ**), d'au moins une ouverture inférieure secondaire supplémentaire (**Oᵢ₂**) et d'au moins ladite ouverture inférieure secondaire (**Oᵢₛ₁**).

5. Procédé de réalisation selon l'une des revendications 1 ou 2, **caractérisé en ce que** la structure comprenant au moins un matériau III-V dit supérieur **(10)** , un matériau III-V dit intermédiaire **(21),** un second matériau III-V dit inférieur **(22),** le procédé comprend :
- la réalisation d'au moins une ouverture supérieure primaire, d'au moins une ouverture intermédiaire primaire, d'au moins une ouverture inférieure primaire ;
- la réalisation d'au moins une ouverture supérieure secondaire, d'au moins une ouverture intermédiaire secondaire et d'au moins une ouverture inférieure secondaire ;
- le remplissage desdites ouvertures.

6. Procédé de réalisation selon la revendication 5, dans lequel :
- au moins ladite ouverture inférieure secondaire comporte trois portions de dimensions différentes (**Oᵢₛ₁**, **Oᵢₛ₂, Oᵢₛ₃**) ;
- au moins ladite ouverture intermédiaire secondaire comporte deux portions de dimensions différentes **(Oₜₛ₁, Oₜₛ₂)** ;
- au moins ladite ouverture supérieure secondaire comporte une portion **(Oₛₛ)**.

7. Procédé de réalisation selon la revendication 1, **caractérisé en ce qu'**il comprend les étapes suivantes :
- l'encapsulation de ladite structure par un premier diélectrique;
- la réalisation d'au moins une ouverture inférieure primaire (**Oᵢₚ**) débouchant sur ledit second matériau III-V (2) ;
- le dépôt de métallisation à la surface dudit premier diélectrique et à la surface dudit second matériau III-V **(2)** définissant une métallisation de fond de contact inférieur et un premier ensemble **(E1)** ;
- l'encapsulation dudit premier ensemble **(E1)** par un second diélectrique;
- la planarisation dudit premier ensemble encapsulé ;
- la réalisation d'au moins une ouverture inférieure secondaire **(Oᵢₛ₁)** débouchant sur ladite métallisation de fond de contact inférieur ;
- le remplissage par au moins une matière métallique de ladite au moins ouverture inférieure secondaire définissant au moins un plot de contact dudit contact inférieur et un second ensemble **(E2):**
- l'encapsulation dudit second ensemble **(E2)** par un troisième diélectrique;
- la réalisation d'au moins une ouverture supérieure primaire au dessus dudit premier matériau III-V **(1);**
- le dépôt de métallisation à la surface dudit troisième matériau diélectrique et de ladite ouverture supérieure définissant une métallisation de fond de contact supérieur et un troisième ensemble **(E3);**
- l'encapsulation dudit troisième ensemble par un quatrième diélectrique;
- la planarisation dudit troisième ensemble ;
- la réalisation d'au moins une ouverture supérieure secondaire (**Oₛₛ**) au dessus de ladite métallisation de fond de contact supérieur et au moins une ouverture supérieure **(Oᵢₛ₂)** au dessus au moins dudit plot de contact dudit contact inférieur;
- le remplissage par au moins une matière métallique de ladite au moins ouverture supérieure secondaire au dessus de ladite métallisation de fond de contact supérieur et de ladite au moins ouverture supérieure au dessus au moins dudit plot de contact dudit contact inférieur, définissant au moins un plot supérieur de contact supérieur et au moins une prolongement de plot de contact inférieur, ledit contact supérieur (**Cₛᵤₚ**) et au moins ledit contact inférieur (**C_{inf}**) présentant une surface définie dans un même plan.

8. Procédé de réalisation selon la revendication 1, **caractérisé en ce qu'**il comporte les étapes suivantes :
- l'encapsulation de ladite structure par un premier diélectrique;
- la réalisation d'au moins une ouverture supérieure primaire (**Oₛₚ**) débouchant sur ledit premier matériau III-V **(1)** ;
- le dépôt de métallisation à la surface dudit premier diélectrique et à la surface dudit premier matériau III-V **(1)** définissant une métallisation de contact supérieur et un premier ensemble **(E1')** ;
- l'encapsulation dudit premier ensemble **(E1')** par un second diélectrique;
- la planarisation dudit premier ensemble encapsulé;
- la réalisation d'au moins une ouverture supérieure secondaire (**Oₛₛ**) débouchant sur ladite métallisation de fond de contact supérieur ;
- le remplissage par au moins une matière métallique de ladite au moins ouverture supérieure secondaire définissant au moins un plot de contact dudit contact supérieur et un second ensemble **(E2');**
- la réalisation d'au moins une ouverture inférieure primaire (**Oᵢₚ**) au dessus dudit second matériau III-V **(2);**
- le dépôt de métallisation à la surface dudit premier matériau diélectrique et de ladite ouverture inférieure primaire définissant une métallisation de contact inférieur et un troisième ensemble **(E3');**
- l'encapsulation dudit troisième ensemble par un quatrième diélectrique;
- la planarisation dudit troisième ensemble ;
- la réalisation d'au moins une ouverture inférieure secondaire (**Oᵢₛ**) au dessus de ladite couche de fond de contact inférieur;
- le remplissage de ladite au moins ouverture inférieure secondaire, définissant au moins un plot de contact inférieur, ledit contact supérieur (**Cₛᵤₚ**) et au moins ledit contact inférieur (**C_{inf}**) présentant une surface définie dans un même plan

9. Procédé de réalisation selon la revendication 1, **caractérisé en ce qu'**il comprend :
- la réalisation simultanée d'au moins une ouverture supérieure primaire et d'au moins une ouverture inférieure primaire ;
- la réalisation simultanée d'au moins une ouverture supérieure secondaire et d'au moins une ouverture inférieure secondaire.

10. Procédé de réalisation selon l'une des revendications 1 à 9, **caractérisé en ce qu'**il comprend la réalisation d'un niveau supplémentaire de contact à la surface desdits contacts planaires, comportant :
- un dépôt supplémentaire de diélectrique **(8)** ;
- la réalisation d'au moins une ouverture supplémentaire inférieure et d'au moins une ouverture supplémentaire supérieure ;
- le remplissage desdites ouvertures supplémentaires par au moins une matière métallique pour définir au moins un contact supplémentaire inférieur (**C_{inf/supl}**) et au moins un contact supplémentaire supérieur (**C_{sup/supl})**.

11. Procédé de réalisation selon l'une des revendications 1 à 10, dans lequel :
- les ouvertures inférieures primaires présentent une largeur (D2) comprise entre 20 µm et 50 µm ;
les ouvertures inférieures secondaires présentent une largeur (D6) comprise entre 0,5 µm et 5 µm, préférentiellement comprise entre 1 µm et 3 µm.

12. Procédé de réalisation selon l'une des revendications 1 à 10, dans lequel :
- les ouvertures inférieures primaires présentent une largeur (D2) comprise entre 20 µm et 50 µm ;
- les ouvertures inférieures secondaires présentent une largeur (D6) comprise entre 0,5 µm et 5 µm, préférentiellement comprise entre 1 µm et 3 µm.

13. Procédé de réalisation selon l'une des revendications 1 à 12, **caractérisé en ce que** le premier matériau III-V et/ou le second matériau III-V sont choisis parmi : InP, In₁₋ₓGaₓAs (avec 0 ≤ x ≤ 1), GaAs, InAs, du GaSb, In₁₋ₓGaₓS_{b}, InₓGa₁₋ₓAs_{1-y}P_{y}, Ga₁₋ₓInₓP, InₓGa₁₋ₓAs_{1-y}N_{y}, BₓIn_{y}Ga_{1-x-y}As_{.}

14. Procédé de réalisation selon l'une des revendications 1 à 13, **caractérisé en ce que** le substrat est en silicium.

15. Procédé de réalisation selon l'une des revendications 1 à 14, dans lequel le ou les diélectriques sont choisis parmi : SiN, SiO₂, Al₂O₃, un polymère planarisant pouvant être à base de Benzocyclobutène (BCB) ou SOG.

16. Procédé de réalisation selon l'une des revendications 1 à 15, dans lequel on réalise le dépôt d'un métal tel que Ni₂P, Ni₃P, NiGe, TiP, TiGe dans lesdites ouvertures primaires.

17. Procédé de réalisation selon l'une des revendications 1 à 15, dans lequel on réalise le dépôt d'un métal tel que Ni, Ti et alliage comme NiPt, NiTi, NiCo dans lesdites ouvertures primaires.

18. Procédé de réalisation selon l'une des revendications 1 à 16, dans lequel le dépôt de métallisation est suivi d'un traitement thermique pour former un ou plusieurs composé(s) intermétallique(s)

19. Procédé de réalisation selon l'une des revendications 1 à 18, **caractérisé en ce que** les opérations de remplissage comprennent :
- le dépôt d'une barrière de diffusion pouvant être composée d'une ou plusieurs couches de matériau choisi parmi : TiN, Ti/TiN, TaN, Ta/TaN, W;
- le dépôt d'un métal de remplissage choisi parmi : W, Cu, Al, AlCu, AlSi.

20. Procédé de réalisation selon l'une des revendications 1 à 19, dans lequel le composant étant un laser, ledit procédé comprend une opération pour réaliser un guide **(91)** en matériau semiconducteur pouvant être du Si, dans un substrat diélectrique **(90)** pouvant être en SiO₂.

21. Procédé de réalisation selon l'une des revendications 1 à 19, dans lequel le composant étant un laser, ledit procédé comprend la réalisation d'un contact supérieur circulaire pour permettre l'émission verticale du rayonnement laser, au centre dudit contact supérieur.

## Patentansprüche

1. Verfahren zum Herstellen einer Komponente, umfassend eine Struktur aus III-V-Material(ien) auf der Oberfläche eines Substrats, wobei die Struktur mindestens eine obere Kontaktebene (Nₛᵤₚ), die auf der Oberfläche eines ersten III-V-Materials (1) definiert ist, das sich seitlich über das Substrat erstreckt, und eine untere Kontaktebene (N_{inf}) umfasst, die auf der Oberfläche eines zweiten III-V-Materials (2) definiert ist, das sich seitlich über das Substrat erstreckt, das Folgendes umfasst:
- Einkapseln der Struktur mit mindestens einem Dielektrikum (8);
- Herstellen mindestens einer oberen primären Öffnung (Oₛₚ) in dem Dielektrikum (8) an der Oberfläche des ersten III-V-Materials (1) und mindestens einer unteren primären Öffnung (Oᵢₚ) an der Oberfläche des zweiten III-V-Materials (2), um Kontaktbodenzonen auf dem ersten III-V-Materials und dem zweiten III-V-Materials zu definieren;
- Herstellen von Kontaktbodenmetallisierungen (3) in der mindestens einen oberen primären Öffnung und in der mindestens einen unteren primären Öffnung, um eine Zwischenstruktur zu bilden;
- Einkapseln der Zwischenstruktur mit mindestens einem Dielektrikum (8) der mindestens einen oberen primären Öffnung (Oₛₚ) und der mindestens einen unteren primären Öffnung (Oᵢₚ);
- Herstellen mindestens einer oberen sekundären Öffnung (Oₛₛ) in dem Dielektrikum, das sich in der mindestens einen oberen primären Öffnung (Oₛₚ) befindet, und Herstellen mindestens einer unteren sekundären Öffnung (Oᵢₛ) in dem Dielektrikum, das sich in der unteren primären Öffnung (Oᵢₚ) befindet,
- Füllen der mindestens einen oberen sekundären Öffnung (Oₛₛ) und der mindestens einen unteren sekundären Öffnung (Oᵢₛ) mit mindestens einem metallischen Material (5), um mindestens ein oberes Kontaktpad auf einer Kontaktbodenmetallisierungsfläche, die kleiner ist als die Fläche der in der mindestens einen oberen primären Öffnung abgeschiedenen Kontaktbodenmetallisierung, und mindestens ein unteres Kontaktpad auf einer Kontaktbodenmetallisierungsfläche herzustellen, die kleiner ist als die Fläche der in der mindestens einen unteren primären Öffnung abgeschiedenen Kontaktbodenmetallisierung; - wobei die Kontaktbodenmetallisierungen und die Kontaktpads mindestens einen oberen Kontakt des ersten III-V-Materials in Kontakt mit der oberen Kontaktebene (Nₛᵤₚ) und mindestens einen unteren Kontakt des zweiten 111-V-Materials in Kontakt mit der unteren Kontaktebene (N_{inf}) definieren;
- mindestens der obere Kontakt und mindestens der untere Kontakt sind teilweise in ein Dielektrikum integriert und weisen eine obere Fläche auf, die nicht von dem Dielektrikum bedeckt und in einer selben Ebene definiert ist;
- wobei die Kontaktbodenmetallisierungen (3) von anderer Art sind als die des metallischen Materials (5);
- wobei die Struktur eine untere Basis aus einem zweiten III-V-Material (2) und eine Mesa aus einem ersten III-V-Material (1) aufweist, die sich über der Basis befindet.

2. Herstellungsverfahren nach Anspruch 1, **dadurch gekennzeichnet, dass** es das aufeinanderfolgende Herstellen mindestens einer oberen primären Öffnung und dann mindestens einer unteren primären Öffnung umfasst.

3. Herstellungsverfahren nach Anspruch 1, **dadurch gekennzeichnet, dass** es das gleichzeitige Herstellen mindestens einer oberen sekundären Öffnung und mindestens einer unteren sekundären Öffnung umfasst.

4. Herstellungsverfahren nach Anspruch 1 bis 3, **dadurch gekennzeichnet, dass** es Folgendes umfasst:
- Einkapseln einer Baugruppe, die das mit einer Metallisierung (3) bedeckte III-V-Material (1) und das mit einer Metallisierung (3) bedeckte III-V-Material (2) umfasst, mit einem Dielektrikum;
- Herstellen mindestens einer unteren sekundären Öffnung (Oᵢₛ₁) gegenüber dem zweiten Material III-V (2);
- Herstellen mindestens einer oberen sekundären Öffnung (Oₛₛ) über dem ersten III-V-Material (1) und Herstellen mindestens einer zusätzlichen unteren sekundären Öffnung (Oᵢₛ₂) über mindestens der unteren sekundären Öffnung (Oᵢₛ₁);
- Füllen mindestens der einen oberen sekundären Öffnung (Oₛₛ), mindestens der einen zusätzlichen unteren sekundären Öffnung (Oᵢₛ₂) und mindestens der einen unteren sekundären Öffnung (Oᵢₛ₁).

5. Herstellungsverfahren nach Anspruch 1 oder 2, **dadurch gekennzeichnet, dass**, da die Struktur mindestens ein sogenanntes oberes III-V-Material (10), ein sogenanntes intermediäres III-V-Material (21), ein zweites sogenanntes unteres III-V-Material (22) umfasst, das Verfahren Folgendes umfasst:
- Herstellen mindestens einer oberen primären Öffnung, mindestens einer intermediären primären Öffnung, mindestens einer unteren primären Öffnung;
- Herstellen mindestens einer oberen sekundären Öffnung, mindestens einer intermediären sekundären Öffnung und mindestens einer unteren sekundären Öffnung;
- Füllen der Öffnungen.

6. Herstellungsverfahren nach Anspruch 5, wobei:
- mindestens die untere sekundäre Öffnung drei Abschnitte mit unterschiedlichen Abmessungen (Oᵢₛ₁, Oᵢₛ₂, Oᵢₛ₃) aufweist;
- mindestens die intermediäre sekundäre Öffnung zwei Abschnitte mit unterschiedlichen Abmessungen (Oₜₛ₁, Oₜₛ₂) aufweist;
- mindestens die obere sekundäre Öffnung einen Abschnitt (Oₛₛ) aufweist.

7. Herstellungsverfahren nach Anspruch 1, **dadurch gekennzeichnet, dass** es die folgenden Schritte umfasst:
- Einkapseln der Struktur mit einem ersten Dielektrikum;
- Herstellen mindestens einer unteren primären Öffnung (Oᵢₚ), die in das zweite III-V-Material (2) mündet;
- Abscheiden von Metallisierung auf die Oberfläche des ersten Dielektrikums und auf die Oberfläche des zweiten III-V-Materials (2), wodurch eine untere Kontaktbodenmetallisierung und eine erste Baugruppe (E1) definiert werden;
- Einkapseln der ersten Baugruppe (E1) mit einem zweiten Dielektrikum;
- Planarisieren der eingekapselten ersten Baugruppe;
- Herstellen mindestens einer unteren sekundären Öffnung (Oᵢₛ₁), die in die untere Kontaktbodenmetallisierung mündet;
- Füllen der mindestens unteren sekundären Öffnung, die mindestens ein Kontaktpad des unteren Kontakts und eine zweite Baugruppe (E2) definiert, mit mindestens einem metallischen Material;
- Einkapseln der zweiten Baugruppe (E2) mit einem dritten Dielektrikum;
- Herstellen mindestens einer oberen primären Öffnung über dem ersten III-V-Material (1);
- Abscheiden von Metallisierung auf die Oberfläche des dritten dielektrischen Materials und der oberen Öffnung, wodurch eine obere Kontaktbodenmetallisierung und eine dritte Baugruppe (E3) definiert werden;
- Einkapseln der dritten Baugruppe mit einem vierten Dielektrikum;
- Planarisieren der dritten Baugruppe;
- Herstellen mindestens einer oberen sekundären Öffnung (Oₛₛ) über der oberen Kontaktbodenmetallisierung und mindestens einer oberen Öffnung (Oᵢₛ₂) über mindestens dem Kontaktpad des unteren Kontakts;
- Füllen der mindestens einen oberen sekundären Öffnung über der oberen Kontaktbodenmetallisierung und der mindestens einen oberen Öffnung über mindestens dem Kontaktpad des unteren Kontakts mit mindestens einem metallischen Material, wodurch mindestens ein oberes Kontaktpad des oberen Kontakts und mindestens eine untere Kontaktpadverlängerung definiert werden, wobei der obere Kontakt (Cₛᵤₚ) und mindestens der untere Kontakt (C_{inf}) eine in einer selben Ebene definierte Fläche aufweisen.

8. Herstellungsverfahren nach Anspruch 1, **dadurch gekennzeichnet, dass** es die folgenden Schritte umfasst:
- Einkapseln der Struktur mit einem ersten Dielektrikum;
- Herstellen mindestens einer oberen primären Öffnung (Oₛₚ), die in das erste III-V-Material (1) mündet;
- Abscheiden von Metallisierung auf die Oberfläche des ersten Dielektrikums und auf die Oberfläche des ersten III-V-Materials (1), wodurch eine obere Kontaktmetallisierung und eine erste Baugruppe (E1') definiert werden;
- Einkapseln der ersten Baugruppe (E1') mit einem zweiten Dielektrikum;
- Planarisieren der eingekapselten ersten Baugruppe;
- Herstellen mindestens einer oberen sekundären Öffnung (Oₛₛ), die in die obere Kontaktbodenmetallisierung mündet;
- Füllen der mindestens einen oberen sekundären Öffnung, die mindestens ein Kontaktpad des oberen Kontakts und eine zweite Baugruppe (E2') definiert, mit mindestens einem metallischen Material;
- Herstellen von mindestens einer unteren primären Öffnung (Oᵢₚ) über dem zweiten III-V-Material (2);
- Abscheiden von Metallisierung auf die Oberfläche des ersten dielektrischen Materials und der unteren primären Öffnung, wodurch eine untere Kontaktmetallisierung und eine dritte Baugruppe (E3') definiert werden;
- Einkapseln der dritten Baugruppe mit einem vierten Dielektrikum;
- Planarisieren der dritten Baugruppe;
- Herstellen mindestens einer unteren sekundären Öffnung (Oᵢₛ) über der unteren Kontaktbodenschicht;
- Füllen der mindestens einen unteren sekundären Öffnung, wodurch mindestens ein unteres Kontaktpad definiert wird, wobei der obere Kontakt (Cₛᵤₚ) und mindestens der untere Kontakt (C_{inf}) eine in einer selben Ebene definierte Fläche aufweisen.

9. Herstellungsverfahren nach Anspruch 1, **dadurch gekennzeichnet, dass** es Folgendes umfasst:
- gleichzeitiges Herstellen mindestens einer oberen primären Öffnung und mindestens einer unteren primären Öffnung;
- gleichzeitiges Herstellen mindestens einer oberen sekundären Öffnung und mindestens einer unteren sekundären Öffnung.

10. Herstellungsverfahren nach einem der Ansprüche 1 bis 9, **dadurch gekennzeichnet, dass** es die Herstellung einer zusätzlichen Kontaktebene auf der Oberfläche der planaren Kontakte umfasst, das Folgendes umfasst:
- zusätzliches Abscheiden von Dielektrikum (8);
- Herstellen mindestens einer unteren zusätzlichen Öffnung und mindestens einer oberen zusätzlichen Öffnung;
- Füllen der zusätzlichen Öffnungen mit mindestens einem metallischen Material, um mindestens einen zusätzlichen unteren Kontakt (C_{inf/supl}) und mindestens einen zusätzlichen oberen Kontakt (C_{sup/supl}) zu definieren.

11. Herstellungsverfahren nach einem der Ansprüche 1 bis 10, wobei:
- die unteren primären Öffnungen eine Breite (D2) zwischen 20 µm und 50 µm haben,
- die unteren sekundären Öffnungen eine Breite (D6) zwischen 0,5 µm und 5 µm, vorzugsweise zwischen 1 µm und 3 µm, haben.

12. Herstellungsverfahren nach einem der Ansprüche 1 bis 10, wobei:
- die unteren primären Öffnungen eine Breite (D2) zwischen 20 µm und 50 µm haben;
- die unteren sekundären Öffnungen eine Breite (D6) zwischen 0,5 µm und 5 µm, vorzugsweise zwischen 1 µm und 3 µm, haben.

13. Herstellungsverfahren nach einem der Ansprüche 1 bis 12, **dadurch gekennzeichnet, dass** das erste III-V-Material und/oder das zweite III-V-Material ausgewählt sind aus: InP, In₁₋ₓGaₓAs (mit 0 ≤ x ≤ 1), GaAs, InAs, GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As_{.}

14. Herstellungsverfahren nach einem der Ansprüche 1 bis 13, **dadurch gekennzeichnet, dass** das Substrat aus Silizium besteht.

15. Herstellungsverfahren nach einem der Ansprüche 1 bis 14, wobei das Dielektrikum oder die Dielektrika ausgewählt sind aus: SiN, SiO₂, Al₂O₃, ein planarisierendes Polymer, das auf Benzocyclobuten (BCB) oder auf SOG basieren kann.

16. Herstellungsverfahren nach einem der Ansprüche 1 bis 15, wobei ein Metall wie Ni₂P, Ni₃P, NiGe, TiP, TiGe in den primären Öffnungen abgeschieden wird.

17. Herstellungsverfahren nach einem der Ansprüche 1 bis 15, wobei ein Metall wie Ni, Ti und Legierungen wie NiPt, NiTi, NiCo in den primären Öffnungen abgeschieden werden.

18. Herstellungsverfahren nach einem der Ansprüche 1 bis 16, wobei auf die Metallisierungsabscheidung eine Wärmebehandlung folgt, um eine oder mehrere intermetallische Verbindung(en) zu bilden.

19. Herstellungsverfahren nach einem der Ansprüche 1 bis 18, **dadurch gekennzeichnet, dass** die Füllvorgänge Folgendes umfassen:
- Abscheiden einer Diffusionsbarriere, die aus einer oder mehreren Materialschichten, ausgewählt aus: TiN, Ti/TiN, TaN, Ta/TaN, W, bestehen kann;
- Abscheiden eines Füllmetalls, ausgewählt aus: W, Cu, Al, AlCu, AlSi.

20. Herstellungsverfahren nach einem der Ansprüche 1 bis 19, wobei, da die Komponente ein Laser ist, das Verfahren einen Vorgang des Herstellens einer Führung (91) aus einem Halbleitermaterial, das Si sein kann, in einem dielektrischen Substrat (90), das aus SiO₂ sein kann, umfasst.

21. Herstellungsverfahren nach einem der Ansprüche 1 bis 19, wobei, da die Komponente ein Laser ist, das Verfahren das Herstellen eines kreisförmigen oberen Kontakts umfasst, um die vertikale Emission von Laserstrahlung in der Mitte des oberen Kontakts zu ermöglichen.

## Claims

1. A process for producing a component comprising a structure of III-V material(s) on the surface of a substrate, said structure comprising at least one upper contact level (Nₛᵤₚ) defined on the surface of a first III-V material (1), which extends laterally above said substrate, and a lower contact level (N_{inf}) defined on the surface of a second III-V material (2), which extends laterally above said substrate, involving:
- encapsulating said structure with at least one dielectric (8);
- producing, in said dielectric (8), at least one primary upper aperture (Oₛₚ) on the surface of said first III-V material (1) and at least one primary lower aperture (Oᵢₚ) on the surface of said second III-V material (2), so as to define contact bottom zones on said first III-V material and on said second III-V material;
- producing contact bottom metallisations (3) in said at least one upper aperture (Os) and in said at least one lower aperture (Oi), to form an intermediate structure;
- encapsulating the intermediate structure with at least one dielectric (8) of said at least one primary upper aperture (Oₛₚ) and of said at least one primary lower aperture (Oᵢₚ);
- producing at least one secondary upper aperture (Oₛₛ) in the dielectric located in said at least one primary upper aperture (Oₛₚ), and producing at least one secondary lower aperture (Oᵢₛ) in the dielectric located in said primary lower aperture (Oᵢₚ);
- filling said at least one secondary upper aperture (Oₛₛ) and said at least one secondary lower aperture (Oᵢₛ) with at least one metallic material (5) so as to produce at least one upper contact pad on a lower contact bottom metallisation surface that is smaller than the surface of the contact bottom metallisation deposited in said at least one primary upper aperture and at least one lower contact pad on a lower contact bottom metallisation surface that is smaller than the surface of the contact bottom metallisation deposited in said at least one primary lower aperture; - the contact bottom metallisations and the contact pads defining at least one upper contact of said first III-V material in contact with said upper contact level (Nₛᵤₚ) and at least one lower contact of said second III-V material in contact with said lower contact level (N_{inf});
- at least said upper contact and at least said lower contact are integrated in dielectric and have an upper surface which is not covered by the dielectric and defined in one and the same plane;
- the contact bottom metallisations (3) being of a different nature than that of the metallic material (5);
- said structure having a lower base made of second III-V material (2) and a mesa made of first III-V material (1) located above said base.

2. The production process according to claim 1, **characterised in that** it comprises successively producing at least one primary upper aperture, then at least one primary lower aperture.

3. The production process according to claim 1, **characterised in that** it comprises simultaneously producing at least one secondary upper aperture and at least one secondary lower aperture.

4. The production process according to claims 1 to 3, **characterised in that** it involves:
- encapsulating an assembly comprising the III-V material (1) covered with a metallisation (3) and the III-V material (2) covered with a metallisation (3), with dielectric;
- producing at least one secondary lower aperture (Oᵢₛ₁) opposite the second III-V material (2);
- producing at least one secondary upper aperture (Oₛₛ) above said first III-V material (1) and producing at least one additional secondary lower aperture (Oᵢₛ₂) above at least said secondary lower aperture (Oᵢₛ₁);
- filling at least said secondary upper aperture (Oₛₛ), at least one additional secondary lower aperture (Oᵢₛ₂) and at least said secondary lower aperture (Oᵢₛ₁).

5. The production process according to one of claims 1 or 2, **characterised in that**, the structure comprising at least a so-called upper III-V material (10), a so-called intermediate III-V material (21), a second so-called lower III-V material (22), the process comprises:
- producing at least one primary upper aperture, at least one primary intermediate aperture, at least one primary lower aperture;
- producing at least one secondary upper aperture, at least one secondary intermediate aperture and at least one secondary lower aperture;
- filling said apertures.

6. The production process according to claim 5, wherein:
- at least said secondary lower aperture has three portions with different dimensions (Oᵢₛ₁, Oᵢₛ₂, Oᵢₛ₃);
- at least said secondary intermediate aperture has two portions with different dimensions (Oₜₛ₁, Oₜₛ₂);
- at least said secondary upper aperture contains a portion (Oₛₛ).

7. The production process according to claim 1, **characterised in that** it comprises the following steps:
- encapsulating said structure with a first dielectric;
- producing at least one primary lower aperture (Oᵢₚ) opening onto said second III-V material (2);
- depositing metallisation on the surface of said first dielectric and on the surface of said second III-V material (2) defining a lower contact bottom metallisation and a first assembly (E1);
- encapsulating said first assembly (E1) with a second dielectric;
- planarising said encapsulated first assembly;
- producing at least one secondary lower aperture (Oᵢₛ₁) opening onto said lower contact bottom metallisation;
- filling, with at least one metallic material, said at least one secondary lower aperture defining at least one contact pad of said lower contact and a second assembly (E2):
- encapsulating said second assembly (E2) with a third dielectric;
- producing at least one primary upper aperture above said first III-V material (1);
- depositing metallisation on the surface of said third dielectric material and of said upper aperture defining an upper contact bottom metallisation and a third assembly (E3);
- encapsulating said third assembly with a fourth dielectric;
- planarising said third assembly;
- producing at least one secondary upper aperture (Oₛₛ) above said upper contact bottom metallisation and at least one upper aperture (Oᵢₛ₂) above at least said contact pad of said lower contact;
- filling, with at least one metallic material, said at least one secondary upper aperture above said upper contact bottom metallisation and said at least one upper aperture above at least said contact pad of said lower contact, defining at least one upper pad for upper contact and at least one prolongation of lower contact pad, said upper contact (Cₛᵤₚ) and at least said lower contact (C_{inf}) having a surface defined in one and the same plane.

8. The production process according to claim 1, **characterised in that** it involves the following steps:
- encapsulating said structure with a first dielectric;
- producing at least one primary upper aperture (Oₛₚ) opening onto said first III-V material (1);
- depositing metallisation on the surface of said first dielectric and on the surface of said first III-V material (1) defining an upper contact metallisation and a first assembly (E1');
- encapsulating said first assembly (E1') with a second dielectric;
- planarising said encapsulated first assembly;
- producing at least one secondary upper aperture (Oₛₛ) opening onto said upper contact bottom metallisation;
- filling, with at least one metallic material, said at least one secondary upper aperture defining at least one contact pad of said upper contact and a second assembly (E2');
- producing at least one primary lower aperture (Oᵢₚ) above said second III-V material (2);
- depositing metallisation on the surface of said first dielectric material and of said primary lower aperture defining a lower contact metallisation and a third assembly (E3');
- encapsulating said third assembly with a fourth dielectric;
- planarising said third assembly;
- producing at least one secondary lower aperture (Oᵢₛ) above said lower contact bottom layer;
- filling said at least one secondary lower aperture, defining at least one lower contact pad, said upper contact (Cₛᵤₚ) and at least said lower contact (C_{inf}) having a surface defined in one and the same plane.

9. The production process according to claim 1, **characterised in that** it comprises:
- simultaneously producing at least one primary upper aperture and at least one primary lower aperture;
- simultaneously producing at least one secondary upper aperture and at least one secondary lower aperture.

10. The production process according to one of claims 1 to 9, **characterised in that** it involves producing an additional contact level on the surface of said planar contacts, involving:
- depositing additional dielectric (8);
- producing at least one lower additional aperture and at least one upper additional aperture;
- filling said additional apertures with at least one metallic material to define at least one lower additional contact (C_{inf/supl}) and at least one upper additional contact (C_{sup/supl}).

11. The production process according to one of claims 1 to 10, wherein:
- the primary lower apertures have a width (D2) comprised between 20 µm and 50 µm;
- the secondary lower apertures have a width (D6) comprised between 0.5 µm and 5 µm, preferably comprised between 1 µm and 3 µm.

12. The production process according to one of claims 1 to 10, wherein:
- the primary lower apertures have a width (D2) comprised between 20 µm and 50 µm;
- the secondary lower apertures have a width (D6) comprised between 0.5 µm and 5 µm, preferably comprised between 1 µm and 3 µm.

13. The production process according to one of claims 1 to 12, **characterised in that** the first III-V material and/or the second III-V material are selected from: InP, In₁₋ₓGaₓAs (with 0 ≤ x ≤ 1), GaAs, InAs, GaSb, In₁₋ₓGaₓSb, InₓGa₁₋ₓAs_{1-y}P_{y}, Ga₁₋ₓInₓP, InₓGa₁₋ₓAs_{1-y}N_{y}, BₓIn_{y}Ga_{1-x-y}As.

14. The production process according to one of claims 1 to 13, **characterised in that** the substrate is made of silicon.

15. The production process according to one of claims 1 to 14, wherein the dielectric or dielectrics are selected from: SiN, SiO₂, Al₂O₃, a planarising polymer that may be benzocyclobutene-based (BCB) or SOG-based.

16. The production process according to one of claims 1 to 15, wherein a metal such as Ni₂P, Ni₃P, NiGe, TiP, TiGe is deposited in said primary apertures.

17. The production process according to one of claims 1 to 15, wherein a metal such as Ni, Ti and an alloy such as NiPt, NiTi, NiCo are deposited in said primary apertures.

18. The production process according to one of claims 1 to 16, wherein the deposition of metallisation is followed by a heat treatment to form one or more intermetallic compound(s).

19. The production process according to one of claims 1 to 18, **characterised in that** the filling operations comprise:
- depositing a diffusion barrier, which may consist of one or more layers of material selected from: TiN, Ti/TiN, TaN, Ta/TaN, W;
- depositing a filling metal selected from: W, Cu, Al, AlCu, AlSi.

20. The production process according to one of claims 1 to 19, wherein the component being a laser, said process comprises an operation for producing a guide (91) of semiconductor material, which may be Si, in a dielectric substrate (90), which may be made of SiO₂.

21. The production process according to one of claims 1 to 19, wherein the component being a laser, said process comprises producing a circular upper contact to allow vertical emission of the laser radiation, at the centre of said upper contact.
